(19) Europäisches Patentamt
European Patent Office
Office européen des brevets

(11) EP 2 612 378 B1

(12) **EUROPEAN PATENT SPECIFICATION**

(45) Date of publication and mention of the grant of the patent:
**31.10.2018 Bulletin 2018/44**

(21) Application number: **11740852.6**

(22) Date of filing: **04.08.2011**

(51) Int Cl.:
***H01L 51/50*** *(2006.01)* ***H01L 51/52*** *(2006.01)*
***H01L 51/05*** *(2006.01)*

(86) International application number:
**PCT/EP2011/003901**

(87) International publication number:
**WO 2012/028238 (08.03.2012 Gazette 2012/10)**

(54) **QUENCHING OF PHOTOLUMINESCENCE IN AN ORGANIC DEVICE**

PHOTOLUMINESZENZ-QUENCHING IN EINE ORGANISCHE VORRICHTUNG

SUPPRESSION DE LA PHOTOLUMINESCENCE DANS UN DISPOSITIF ORGANIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **01.09.2010 EP 10009064**

(43) Date of publication of application:
**10.07.2013 Bulletin 2013/28**

(73) Proprietor: **Merck Patent GmbH**
**64293 Darmstadt (DE)**

(72) Inventor: **PAN, Junyou**
**60320 Frankfurt am Main (DE)**

(56) References cited:
**GB-A- 2 379 317** **JP-A- 2007 234 989**
**US-A1- 2004 017 148** **US-A1- 2006 208 221**
**US-A1- 2007 176 147** **US-A1- 2008 142 789**

- **KALINOWSKI J ET AL: "Electric-field-induced quenching of photoluminescence in photoconductive organic thin film structures based on Eu3+ complexes", JOURNAL OF APPLIED PHYSICS, AMERICAN INSTITUTE OF PHYSICS. NEW YORK, US, vol. 100, no. 3, 14 August 2006 (2006-08-14), pages 34318-034318, XP012089651, ISSN: 0021-8979, DOI: 10.1063/1.2229577**
- **LI YUN-BAI ET AL: "Electric Field-Induced Quenching of Photoluminescence from Ir(PPY)3-Doped PVK", CHINESE PHYSICS LETTERS, INSTITUTE OF PHYSICS PUBLISHING, BRISTOL, GB, vol. 21, no. 7, 1 July 2004 (2004-07-01), pages 1362-1365, XP020027323, ISSN: 0256-307X, DOI: 10.1088/0256-307X/21/7/050**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 612 378 B1

## Description

The present invention relates to a photoluminescence quenching device induced by electric field as described in claim 1. Furthermore, the present invention relates to a display comprising at least one of the photoluminescence quenching devices according to the invention and a process for controlling and/or regulating photoluminescence.

Organic materials play a crucial role in devices related to display technologies of the next generation, for example organic light emitting diodes (OLEDs), organic field-effect transistors (OFETs) and organic light emitting electrochemical cells (OLECs). Among them, the most attention has been drawn to OLEDs in last the two decades because of their versatility in material design, low production cost and low power consumption. Actually huge improvement has been achieved in the last years regarding the performance of the OLEDs, including the lifetime (particularly for small molecule based OLEDs), its performance being near to commercial requirements. Besides the progress in material development, another big challenge for OLED displays is the backplane. Other than liquid crystal displays (LCDs), which are driven by voltage, OLEDs are driven by current, thus, the present backplane technique for LCD cannot be transferred to the pixels of OLEDs.

It is therefore highly desired to find a method to switch on/off a pixel comprising organic functional materials, especially an emissive compound, by just applying a suitable voltage, so that one can use the backplane of LCDs in connection with displays comprising the advantages of organic materials.

Field quenching of photoluminescence (hereafter FQPL) is an effect that photoluminescence decreases under an electric field, e.g. if a voltage is applied. So far some uses of FQPL have been disclosed.

For instance, Smith et al. describes in GB 2379317 A an optoelectronic display operating by photoluminescence quenching. This display has a device structure same or very similar to OLEDs. As active components conjugated polymers are disclosed which act as photoluminescent materials. The photoluminescence of these materials may be quenched in the optoelectronic display. However, the efficiency of quenching is far from quenching 100% photoluminescence. Therefore, it is a challenge to find a material with a high photoluminescene efficiency and which is easily to be quenched completely or almost completely.

Redecker discloses in US 2004/017148 A1 a display using a photoluminescence quenching device. In another document (DE 102005015359 A1) Redecker discloses an inverted layered structure for organic light-emitting diodes and photoluminescence quenching devices. Further in US 2004/0227143 A1, Redecker discloses a field-quenching device having a hole and/or electron barrier layer in US 2004/0147701 A1, Redecker discloses a material concept for photoluminescence quenching devices: a chemical compound has an electron donor group, an electron acceptor group, and a conjugated bridging element bridging between the electron donor group and the electron acceptor group. However, the materials or devices disclosed by Redecker have no substantial FQPL effect.

Electric-field-induced quenching of photoluminescence in photoconductive organic thin film structures based on Eu3+ complexes, Journal of Applied Physics 100, 034318, J. Kalinowski et Al (2006), studies the effect of electric field on photoluminescence of organic films comprising phosphorescent compounds.

Electric Field-Induced Quenching of photoluminescence from Ir(PPy)3 doped PVK, Chin.Phys.Lett, vol.21, No7 (2004), 1362, LI Yun-Bai et Al, studies the photoluminescence of IrPPy doped PVK under the modulation of an electric field.

US2007/0176147 discloses blend of polymers and triplet emitters which can be used in organic field-quench devices.

US2008/0142789 discloses an organic light emitting device comprising a first, a second and a third electrode, wherein the third electrode is isolated from the active layer by an insulating layer.

JP2007234989 discloses an organic light emitting element comprising a first, a second and a third electrode, wherein the third electrode is isolated from the active layer by an insulating layer and the active layer comprises one organic phosphorescent emitter compound.

It is therefore an object of the present invention to find a material class and/or a device structure to achieve a substantial and/or even better FQPL effect.

The object of the present invention is solved by providing a device as described in claim 1. Additional details of the present invention are described in the dependent claims.

In general an electric field quenching device is a device which is able to quench the photoluminescence of an emitter compound in a respective amount when applying a respective voltage at the electrodes.

The term "organic phosphorescent emitter compound" is to be understood as an organic compound which shows luminescence from an excited state with higher spin multiplicity, namely a spin state > 1, such as an excited triplet state (triplet-emitter compound), a MLCT-mixed state (metal to ligand charge transfer state) or a quintet state (quintet-emitter compound). Suitable compounds serving as phosphorescent emitter compounds are compounds which are emitting light from an excited state, in particular in the visible spectrum, and which furthermore contain at least one atom with atom number of more than 38 and less than 84, preferably more than 56 and less than 80. Examples of preferred organic phosphorescent emitter compounds are disclosed in the documents WO 00/7065, WO 01/41512, WO 02/02714,

WO 02/15645, EP 1191613, EP 1191612, EP 1191614, WO 2005/033244. In general, all organic phosphorescent emitter compounds which are known in the art of organic light emitting diodes (OLEDs) are suitable to be used in the present invention. Particularly preferred organic phosphorescent emitters are organometallic complexes. Herein, a phosphorescent organometallic complex can be any organometallic complex bearing at least one transition metal.

The term "quenching" or "field quenching" as used in this invention means the suppression of photoluminescence of a light emitting material by applying a voltage at two sides of a layer comprising a photoluminescent active material.

The term "photoluminescence" as used herein means a process in which a substance absorbs photons (electromagnetic radiation) having a specific wavelength or a range of wavelengths and then re-radiates photons with another wavelength or a range of wavelengths. Quantum mechanically, this can be described as an excitation to a higher energy state and then a return to a lower energy state accompanied by the emission of a photon. After the optical excitation of, for instance, an organic compound, so-called excitons are formed. The exciton has three destinies, the first one is a radiative decay to the ground state, giving photoluminescence, the second one is a non-radiative decay to the ground state and the third one is the dissociation of the exciton (hereafter also called bound pair of two charges) into free charge carriers, especially under an electric field, which makes the radiative decay into the ground state less efficient. Different theories are developed to describe the bound pair dissociation. Among them the best known are the model by L. Onsager (in J. Chem, Phys. 2. 599 (1934) and Phys. Rev. 54, 554 (1938)) and the model by C. L. Braun (J. Chem. Phys. 80, 4157 (1984)). Here the model by Braun will be use as an example to show the dissociation process. More details on simulation using Braun model could be referred to Pan, J.et al., J. Chem. Phys. 2000, 112 (9), 4305-4309.

The Braun Model is schematically shown in Figure 3. The bound pair could be the lowest-lying singlet, or triplet charge state, which can be created by optical excitation. The bound pair either dissociates into free carriers with an electric-field dependent rate constant $K_d(E)$ or decay to ground state radiatively or non-radiatively with the rate constant $k_1$, which in some cases can be approximated as radiative lifetime. Here the recombination of free charge into bound pair with rate constant $K_r$ is taken into consideration. The dissociation efficiency (or photogeneration efficiency) $\Phi(T, E)$ in this model is given by the following equation (1):

$$\phi(T,E) = \phi_0 \int_0^{\infty} \phi(r,T,E) f(r) dr \qquad \text{Equation (1)}$$

wherein

$$\phi(r,T,E) = \frac{k_d(E)}{k_d(E) + k_1}$$

$$k_d(E) = \frac{\mu e}{\varepsilon\varepsilon_o} \frac{3}{4\pi r^3} e^{-\Delta E/kT} \left( 1 + b + \frac{b^2}{3} + \frac{b^3}{18} + \frac{b^4}{180} + \cdots \right)$$

wherein

$$\Delta E = \frac{e^2}{4\pi\varepsilon\varepsilon_o r} \quad \text{and} \quad b = \frac{e^3 E}{8\pi\varepsilon\varepsilon_o k^2 T^2}$$

*f(r)* is the normalized distribution function of intrapair distances, $\phi_0$ the primary quantum yield, *r* the intrapair distance and $\varepsilon$ the dielectric constant. The parameter $\mu$ denotes the charge carrier mobility and the other parameters have their usual physical meanings.

It was surprisingly found by the inventors of the present invention that the photoluminescence of an organic phosphorescent emitter compound used in the active layer of the electric field quenching device of the present invention can be much more effectively quenched than by using an organic fluorescent emitter in the active layer.

As mentioned above, the active layer of the electric field quenching device of the present invention comprises an organic phosphorescent emitter compound and a charge transporting host compound. Moreover, the active layer may comprise further emitter compound and/or further charge transport compound.

It is preferred that the phosphorescent emitter compound of the devices of the present invention is a photoluminescent organo-metal complex.

The organo-metal complex in the active layer of the electric field quenching device of the present invention preferably comprises a metal M, which is preferably a transition metal, a main group metal or a lanthanide or actinide. If M is a main group metal, it is preferably a metal of the third, fourth or fifth main group, in particular Zn. Is M a transition metal, it is preferably Ir, Ru, Os, Eu, Pt, Zn, Cu, Mo, W, Rh, Re, Au and Pd, particularly preferred Ru and Ir. As lanthanide, Eu is preferred.

The organo-metal complex further comprises ligands which form coordination compounds with the metal of the organo-metal complex. The ligand is preferably an organic compound. If M is a transition metal it is preferably a tetra-coordinated, a penta-coordinated or a hexa-coordinated transition metal, in particular chosen from the group consisting of Cr, Mo, W, Rh, Ru, Os, Re, Ir, Ni, Pd, Pt, Cu, Ag and Au. Particularly preferred is Mo, W, Re, Ru, Os, Ir, Pt, Cu and Au. Even more preferred is Ir and Pt. The metals may exist in different oxidation states.

The metals are preferably in the following oxidation states: Cr(0), Cr(II), Cr(III), Cr(IV), Cr(VI), Mo(0), Mo(II), Mo(III), Mo(IV), Mo(VI), W(0), W(II), W(III), W(IV), W(VI), Re(I), Re(II), Re(III), Re(IV), Ru(II), Ru(III), Os(II), Os(III), Os(IV), Rh(I), Rh(III), Ir(I), Ir(III), Ir(IV), Ni(0), Ni(II), Ni(IV), Pd(II), Pt(II), Pt(IV), Cu(I), Cu(II), Cu(III), Ag(I), Ag(II), Au(I), Au(III) and Au(V); more preferred Mo(0), W(0), Re(I), Ru(II), Os(II), Rh(III), Ir(III), Pt(II) and Cu(I), in particular Ir(III) und Pt(II).

It is even more preferred that the metal M is a tetra-coordinated or a hexa-coordinated metal.

The ligands of the organo-metal complex are preferably mono-, bi-, tri-, tetra-, penta- or hexadentate ligands.

If M is a hexa-coordinated metal, there exists in dependency of the amount m of the ligands the following coordinative possibilities:

m = 2: M is coordinated with two tridentate ligands or with one tetradentate and one bidentate ligand or with a pentadentate and a monodentate ligand;

m = 3: M is coordinated with three bidentate ligands or with one tridentate, one bidentate and one monodentate ligand or with one tetradentate and two monodentate ligands;

m = 4: M is coordinated with two bidentate and two monodentate ligands or one tridentate and three monodentate ligands;

m = 5: M is coordinated with one bidentate and four monodentate ligands;

m = 6: M is coordinated with six monodentate ligands.

Even more preferred is, if M is a hexa-coordinated metal, m = 3 and the ligands are each bidentate ligands.

If M is a tetra-coordinated metal, there exist in dependency of the amount m of the ligands the following coordinative possibilities:

m = 2: M is coordinated with two bidentate ligands or with one tridentate and one monodentate ligands;

m = 3: M is coordinated with one bidentate and two monodentate ligands;

m = 4: M is coordinated with four monodentate ligands.

Even more preferred is, if M is a tetra-coordinated metal, m = 2 and the ligands are bidentate ligands.

The ligands of the organo-metal complex are preferably neutral, monoanionic, dianionic or trianionic ligands, even more preferred neutral or monoanionic ligands. They may be monodentate, bidentate, tridentate, tetradentate, pentadentate or hexadentate, and are preferably bidentate, which means that there exists two coordination positions at the metal, with respect to one ligand.

Furthermore, it is preferred according to the invention, that in each case at least one ligand of the organo-metal complex is a bidentate ligand.

Preferred neutral, monodentate ligands of the organo-metal complex are selected from the group consisting of CO, NO, alkylcyanides, such as acetonitrile, arylcyanides, such as benzonitrile, alkylisocyanides, such as methylisonitrile, arylisocyanides, such as benzoisonitrile, amines, such as trimethylamine, triethylamine, morpholine, phosphines, in particluar halogenphosphines, trialkylphosphines, triarylphosphines or alkylarylphosphines, such as trifluorophosphine, trimethylphosphine, tricyclohexylphosphine, tri-*tert*-butylphosphine, triphenylphosphine, tris(pentafluorophenyl)phosphine, phosphites, such as trimethylphosphite, triethylphosphite, arsines, such as trifluorarsine, trimethylarsine, tricyclohexylarsine, tri-*tert*-butylarsine, triphenylarsine, tris(pentafluorophenyl)-arsine, stibines, such as trifluorostibine, trimethylstibine, tricyclohexylstibine, tri-*tert*-butylstibine, triphenylstibine, tris(pentafluorophenyl)stibine, N-containing heterocycles, such as pyridine, pyridazine, pyrazine, pyrimidine, triazine, and carbenes, in particular Arduengo-carbenes.

Preferred monoanionic, monodentate ligands of the organo-metal complex are selected from the group consisting of hydride, deuteride, the halogenides $F^-$, $Cl^-$, $Br^-$ und $I^-$, alkylacetylides, such as methyl-C≡C$^-$, tert-butyl-C≡C$^-$, arylacetylides, such as phenyl-C≡C$^-$, cyanide, cyanate, isocyanate, thiocyanate, isothiocyanate, aliphatic or aromatic alcoholates, such as methanolate, ethanolate, propanolate, iso-propanolate, *tert*-butylate, phenolate, aliphatic or aromatic thioalcoholates, such as methane thiolate, ethane thiolate, propane thiolate, *iso*-propane thiolate, *tert*-thiobutylate, thiophenolate, amides, such as dimethylamide, diethylamide, di-*iso*-propylamide, morpholide, carboxylates, such as acetate, trifluoroacetate, propionate, benzoate, arylgroups, such as phenyl, naphthyl, and anionic, N-containing heterocycles, such as pyrrolide, imidazolide, pyrazolide. The alkylgroups in these groups are preferably $C_1$-$C_{20}$-alkylgroups, more preferred $C_1$-$C_{10}$-alkylgroups, even more preferred $C_1$-$C_4$-alkylgroups. Arylgroups also include heteroarylgroups. These groups are as defined below.

Preferred di- or trianionic ligands of the organic-metal complex are $O^{2-}$, $S^{2-}$, carbide, which lead to a coordination in the form of R-C≡M, nitrenes, which lead to a coordination in the form of R-N=M, wherein R generally denotes a substituent, and $N^{3-}$.

Preferred neutral or mono- or dianionic, bidentate or higher-dentate ligands of the organo-metal complex are selected from the group consisting of diamines, such as ethylene diamine, N,N,N',N'-tetramethylethylene diamine, propylene diamine, N,N,N',N'-tetramethylpropylene diamine, cis- or trans-diaminocyclohexane, cis- or trans-N,N,N',N'-tetramethyldiaminocyclohexane, imines, such as 2[1-(phenylimino)ethyl]pyridine, 2[1-(2-methylphenylimino)ethyl]pyridine, 2[1-(2,6-si-*iso*-propylphenylimino)ethyl]pyridine, 2[1-(methylimino)ethyl]pyridine, 2[1-(ethylimino)ethyl]pyridine, 2[1-(*iso*-propylimino)ethyl]pyridine, 2[1-(*tert*-butylimino)ethyl]pyridine, dimines, such as 1,2-bis(methylimino)ethane, 1,2-bis(ethylimino)ethane, 1,2-bis(*iso*-propylimino)ethane, 1,2-bis(*tert*-butylimino)ethane, 2,3-bis(methylimino)butane, 2,3-bis(ethylimino)butane, 2,3-bis(*iso*-propylimino)butane, 2,3-bis(*tert*-butylimino)butane, 1,2-bis-(phenylimino)ethane, 1,2-bis(2-methylphenylimino)ethane, 1,2-bis(2,6-di-*iso*-propylphenylimino)ethane, 1,2-bis(2,6-di-*tert*-butylphenylimino)ethane, 2,3-bis(phenylimino)butane, 2,3-bis(2-methylphenylimino)butane, 2,3-bis-(2,6-di-*iso*-propylphenylimino)butane, 2,3-bis(2,6-di-*tert*-butylphenylimino)-butane, heterocycles containing two N-atoms, such as 2,2'-bipyridine, o-phenanthroline, diphosphines, such as bis(diphenylphosphino)methane, bis(diphenylphosphino)ethane, bis(diphenylphosphino)propane, bis(diphenylphosphino)butane, bis(dimethylphosphino)methane, bis(dimethylphosphino)ethane, bis(dimethylphosphino)propane, bis(diethylphosphino)-methane, bis(diethylphosphino)ethane, bis(diethylphosphino)propane, bis(di-*tert*-butylphosphino)methane, bis(di-*tert*-butylphosphino)ethane, bis(*tert*-butylphosphino)propane, 1,3-diketonates derived from 1,3-diketones, such as acetylacetone, benzoylacetone, 1,5-diphenylacetylacetone, dibenzoylmethane, bis(1,1,1-trifluoroacetyl)methane, 3-ketonates derived from 3-ketoesters, such as ethylester of acetacetic acid, carboxylates, derived from aminocarboxylic acids, pyridine-2-carboxylic acid, chinoline-2-carboxylic acid, glycine, N,N-dimethylglycine, alanine, N,N-dimethylaminoalanine, salicyliminates derived from salicylimines, such as methylsalicylimine, ethylsalicylimine, phenylsalicylimine, dialcoholates derived from dialcoholes, such as ethylene glycole, 1,3-propylene glycole and dithiolates derived from dithioles, such as 1,2-ethylene dithiole, 1,3-propylene dithiole.

Preferred tridentate ligands are borates of N-containing heterocycles, such as tetrakis(1-imidazolyl)borate and tetrakis(1-pyrazolyl)borate.

Further preferred are bidentate monoanionic ligands of the organo-metal complex, which form a cyclometallated five-ring or six-ring with at least one metal-carbon-bond, in particular a cyclometallated five-ring. These are in particular ligands as commonly known in the field of phosphorescent metal-complexes for organic electroluminescence devices, namely ligands of the type phenylpyridine, naphthylpyridine, phenylquinoline, phenylisoquinoline, and so on, which may each be substituted by one or more substituents.

A person skilled in the field of phosphorescent electroluminescent devices knows a plurality of such ligands, and he is also able to choose other kinds of such ligands. Generally preferred is a combination of two groups, as shown by the following Formulae (1) to (28), whereby one group is binding via a neutral nitrogen atom or a carbon atom to the metal and the other group via a negative charged carbon atom or a negative charged nitrogen atom. The ligand of the organo-metal complex can then be formed by groups selected from the Formulae (1) to (28), in that these groups bind to the metal at the position characterized by "#". The position in the below shown formulae which binds to the metal of the organo-metal complex is characterized by "*".

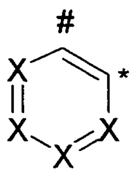

Formula (1)

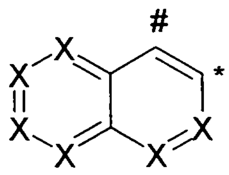

Formula (2)

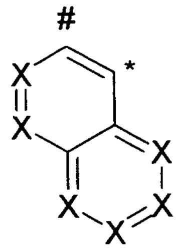

Formula (3)

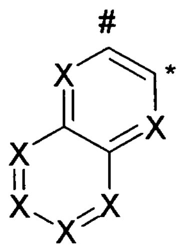

Formula (4)

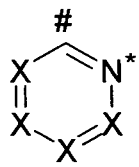

Formula (5)

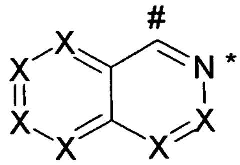

Formula (6)

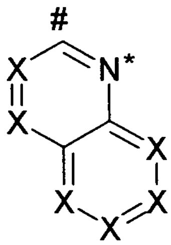

Formula (7)

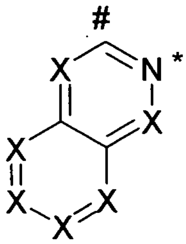

Formula (8)

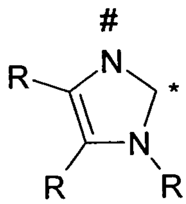

Formula (9)

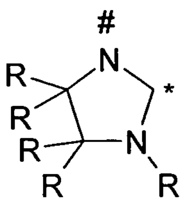

Formula (10)

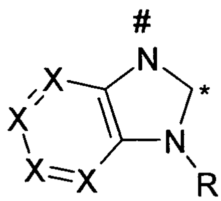

Formula (11)

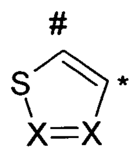

Formula (12)

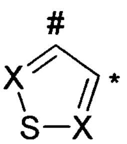

Formula (13)

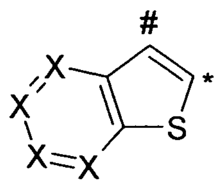

Formula (14)

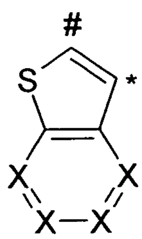

Formula (15)

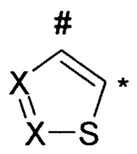

Formula (16)

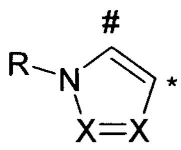

Formula (17)

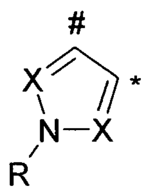

Formula (18)

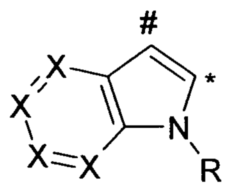

Formula (19)

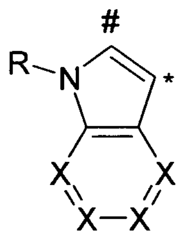

Formula (20)

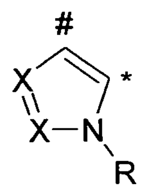

Formula (21)

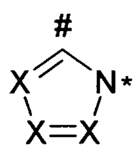

Formula (22)

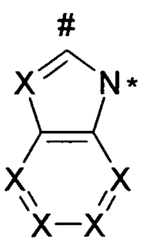

Formula (23)

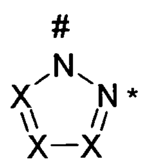

Formula (24)

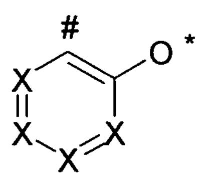

Formula (25)

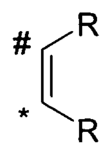

Formula (26)

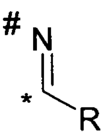

Formula (27)

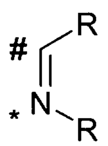

Formula (28)

In the above shown Formulae each R is same or different selected from the group consisting of alkyl, alkylsilyl, silyl, arylsilyl, alkylalcoxyalkyl, arylalcoxyalkyl, alkylthioalkyl, phosphine, phosphinoxide, sulfone, alkylsulfone, sulfoxide and alkylsulfoxide, wherein one or more H-atoms are substituted by F, Cl, Br, I, alkyl or cycloalkyl, whereas one or more $CH_2$ may be substituted by an aromatic or heteroaromatic hydrocarbon group with 5 to 20 aromatic ring atoms. X is N or CH. It is still more preferred, if at most three symbols X in every group are N, especially preferred at most two symbols X in every group are N, and even more preferred at most one symbol X in every group is N. It is most preferred that all symbols X are CH.

In the same way preferred ligands are $\eta^5$-cyclopentadienyl, $\eta^5$-pentamethylcyclopentadienyl, $\eta^6$-benzole or $\eta^7$-cycloheptatrienyl, wherein each of them may be substituted by one or more groups R.

In the same way preferred ligands are derivatives of 1,3,5-cis-cyclohexane, in particular of Formula (29), of 1,1,1-tri(methylene)methane, in particular of Formula (30) and of 1,1,1-trisubstituted methane, in particular of Formula (31) and (32),

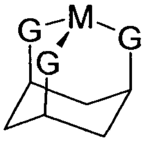

Formula (29)

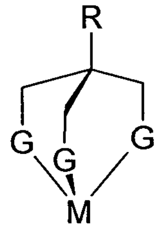

Formula (30)

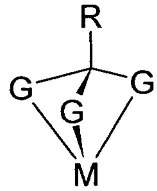

Formula (31)

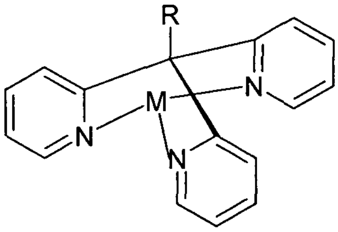

Formula (32)

wherein in each of the Formulae the coordination to the metal M is shown, R has the same meaning as defined above, and each G may be the same or different at every occurrence and is selected from $O^-$, $S^-$, $COO^-$, $P(R)_2$ and $N(R)_2$.

More preferred examples of phosphorescence emitter compounds are compounds having the Formulae (33) to (175).

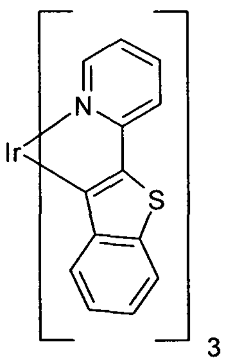

Formula (33)

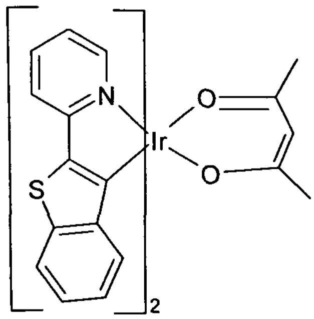

Formula (34)

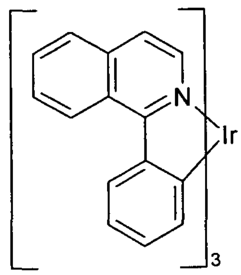

Formula (35)

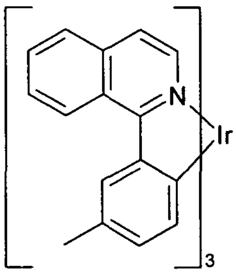

Formula (36)

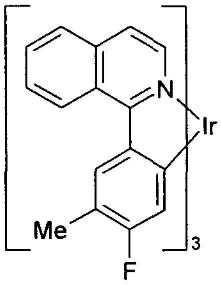

Formula (37)

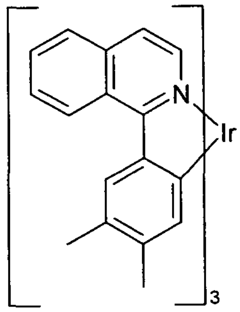

Formula (38)

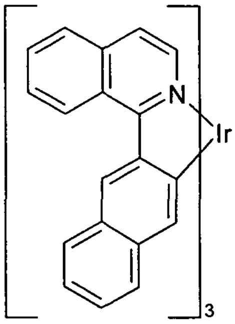

Formula (39)

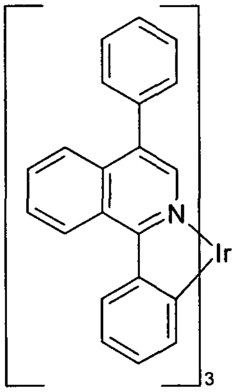

Formula (40)

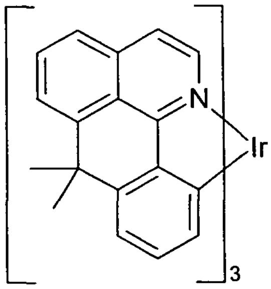

Formula (41)

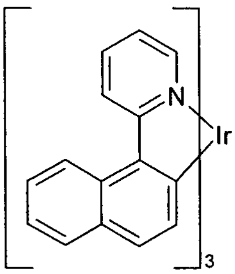

Formula (42)

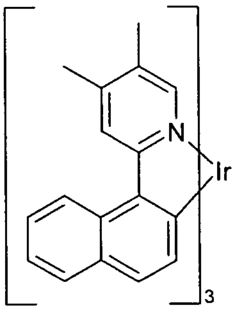

Formula (43)

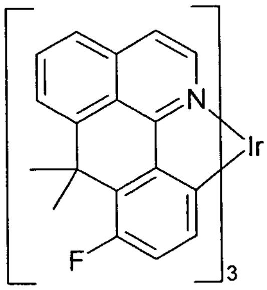

Formula (44)

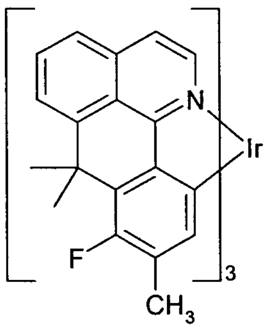

Formula (45)

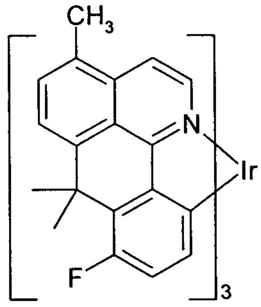

Formula (46)

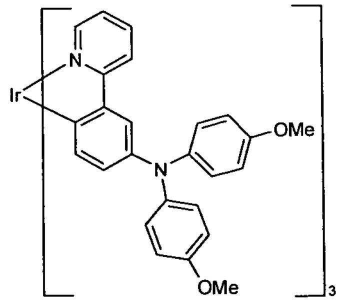

Formula (47)

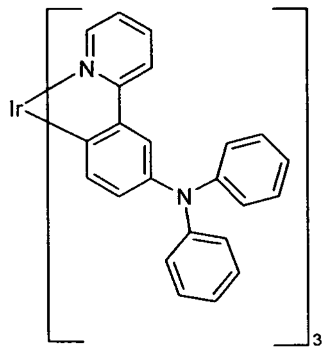

Formula (48)

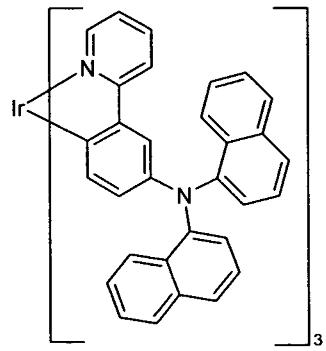

Formula (49)

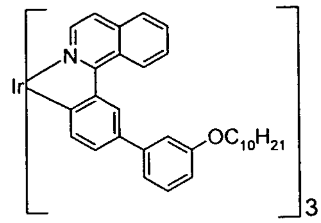

Formula (50)

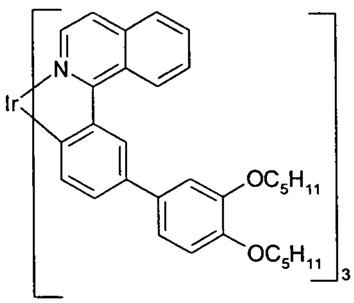

Formula (51)

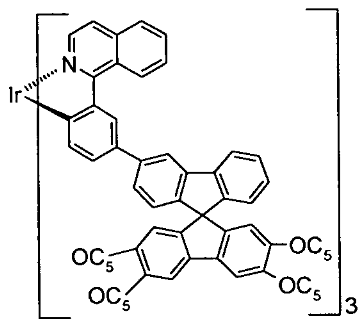

Formula (52)

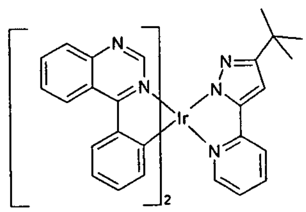

Formula (53)

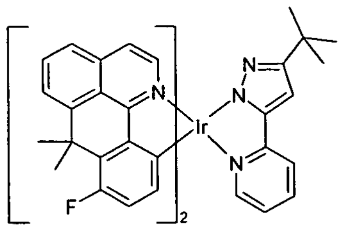

Formula (54)

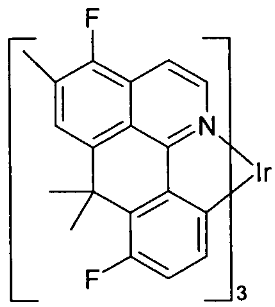

Formula (55)

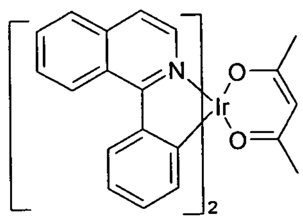

Formula (56)

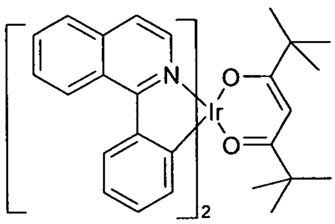

Formula (57)

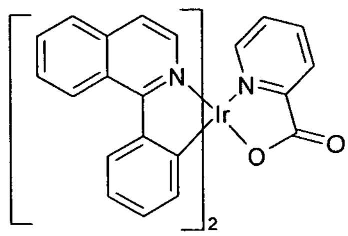

Formula (58)

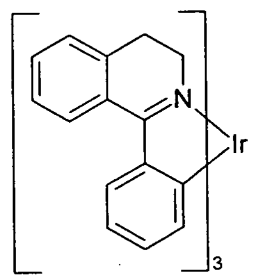

Formula (59)

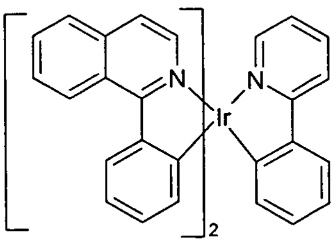

Formula (60)

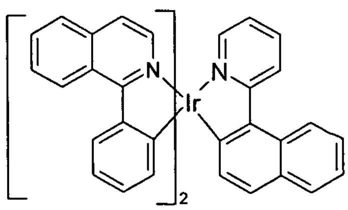

Formula (61)

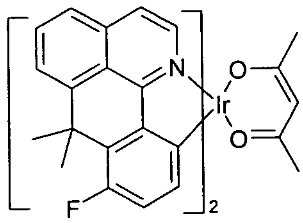

Formula (62)

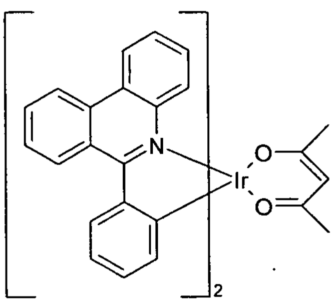

Formula (63)

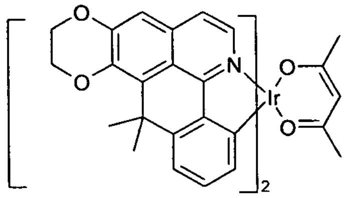

Formula (64)

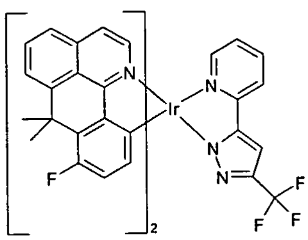

Formula (65)

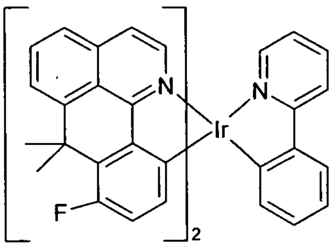

Formula (66)

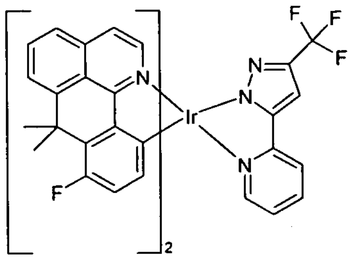

Formula (67)

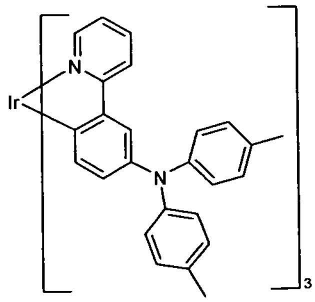

Formula (68)

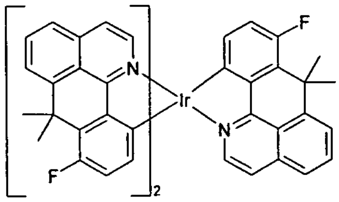

Formula (69)

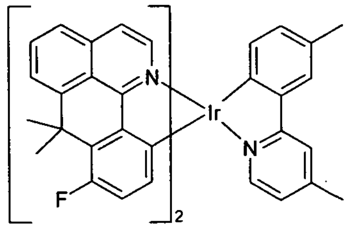

Formula (70)

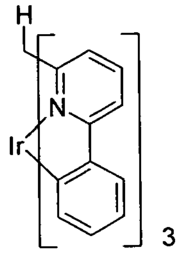

Formula (71)

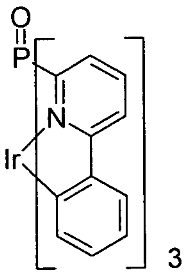

Formula (72)

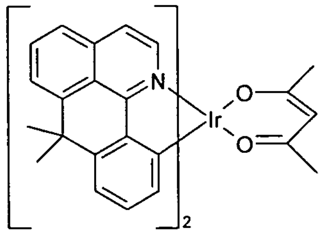

Formula (73)

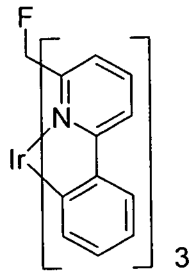

Formula (74)

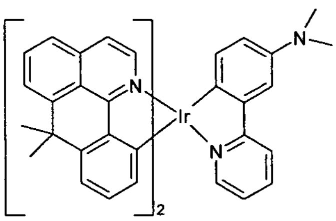

Formula (75)

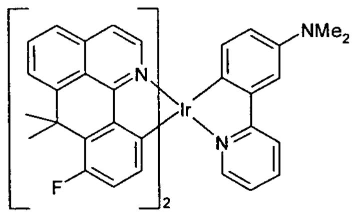

Formula (76)

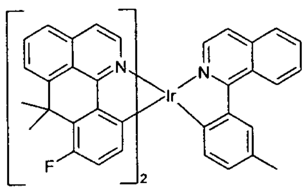

Formula (77)

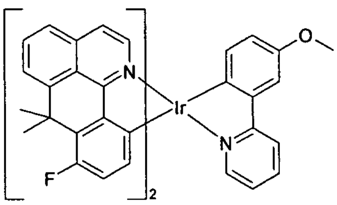

Formula (78)

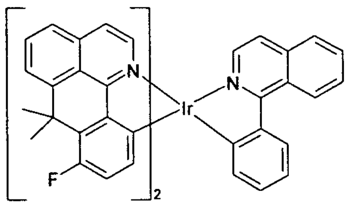

Formula (79)

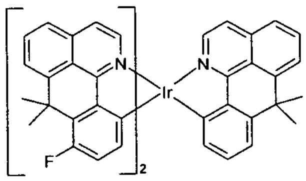

Formula (80)

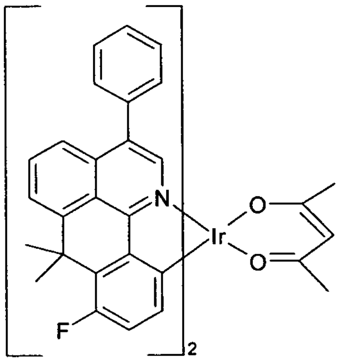

Formula (81)

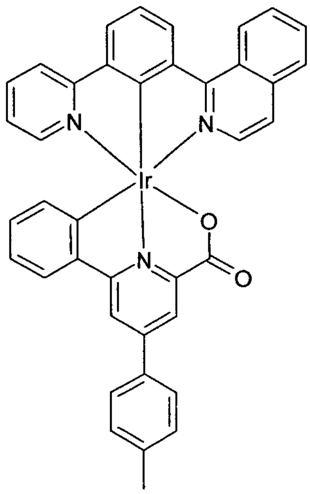

Formula (82)

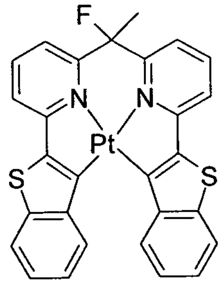

Formula (83)

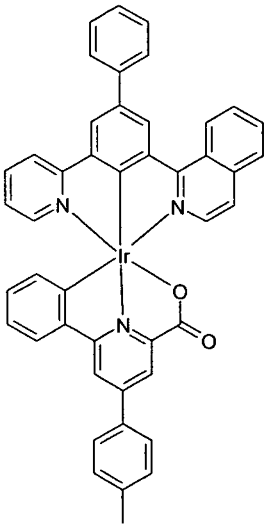

Formula (84)

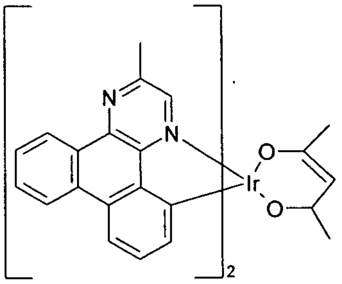

Formula (85)

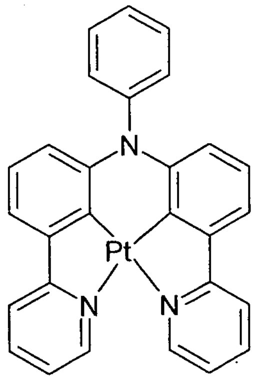

Formula (86)

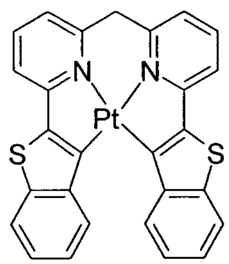

Formula (87)

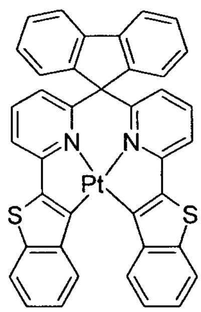

Formula (88)

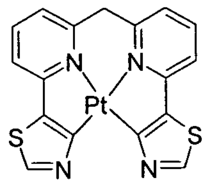

Formula (89)

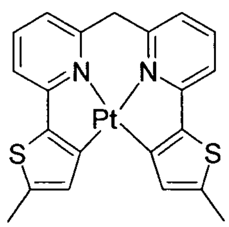

Formula (90)

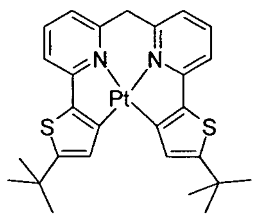

Formula (91)

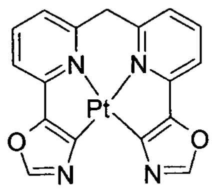

Formula (92)

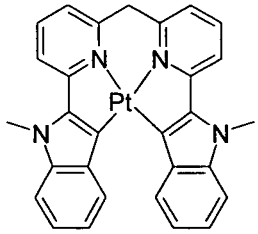

Formula (93)

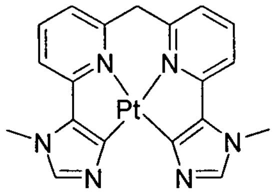

Formula (94)

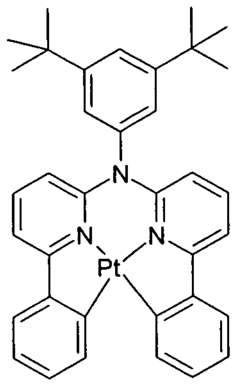

Formula (95)

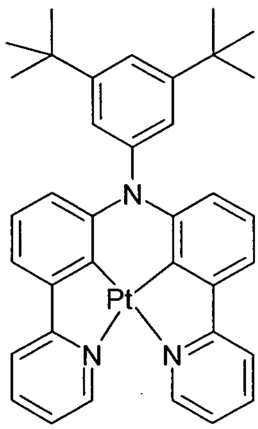

Formula (96)

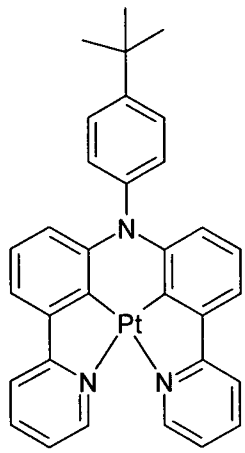

Formula (97)

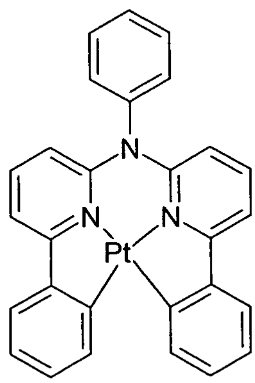

Formula (98)

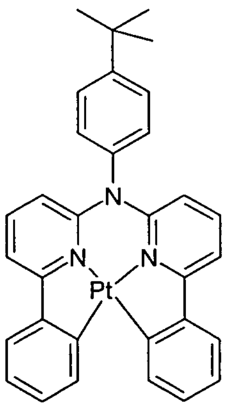

Formula (99)

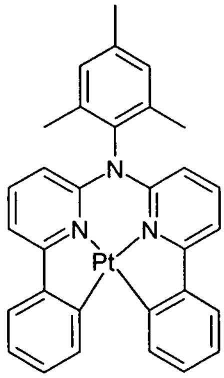

Formula (100)

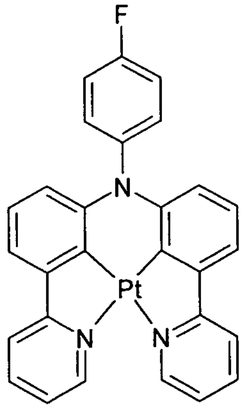

Formula (101)

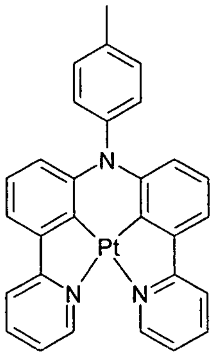

Formula (102)

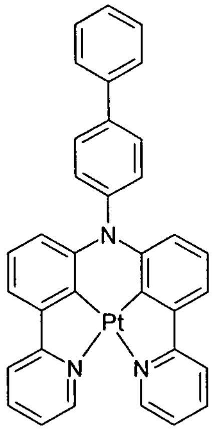

Formula (103)

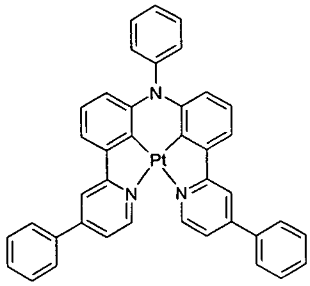

Formula (104)

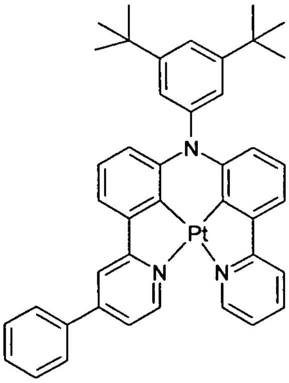

Formula (105)

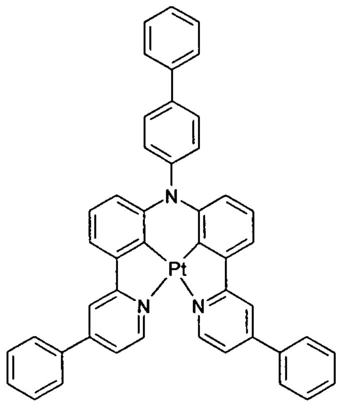

Formula (106)

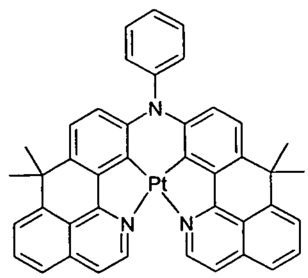

Formula (107)

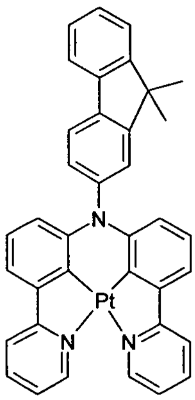

Formula (108)

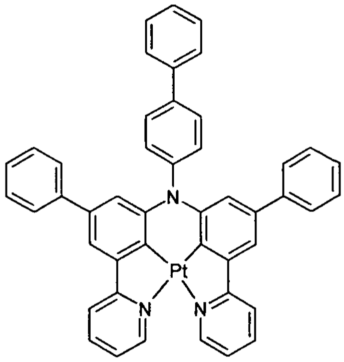

Formula (109)

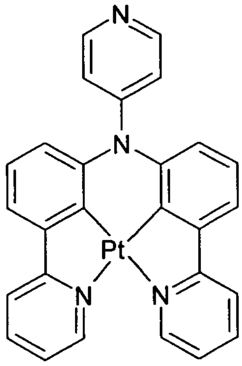

Formula (110)

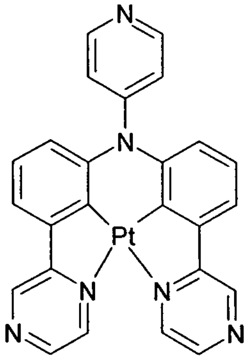

Formula (111)

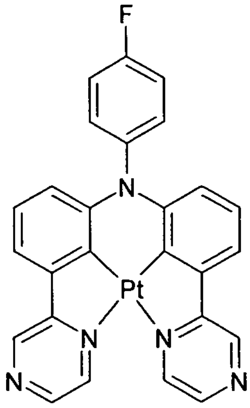

Formula (112)

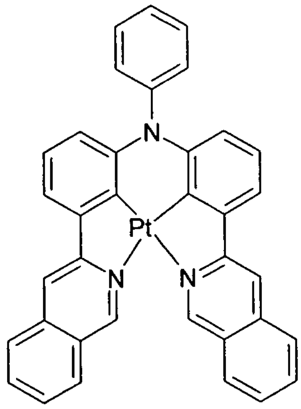

Formula (113)

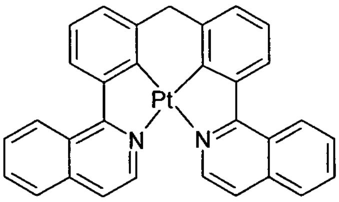

Formula (114)

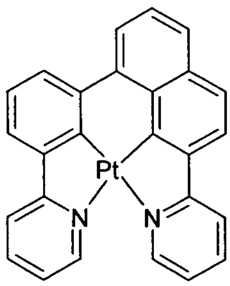

Formula (115)

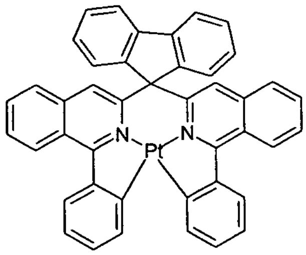

Formula (116)

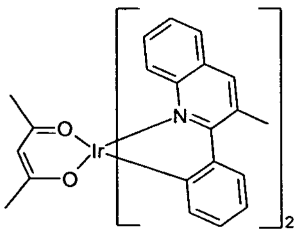

Formula (117)

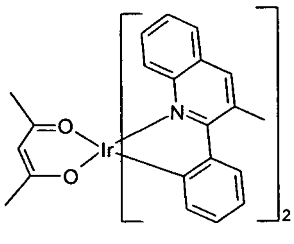

Formula (118)

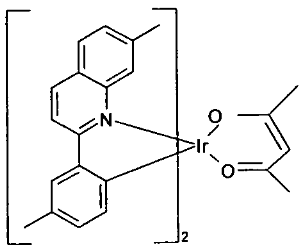

Formula (119)

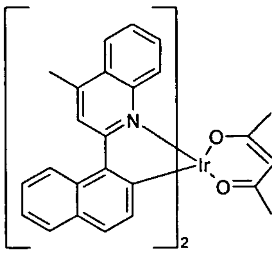

Formula (120)

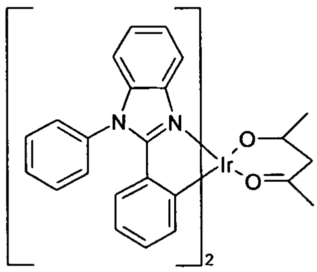

Formula (121)

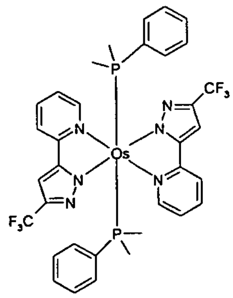

Formula (122)

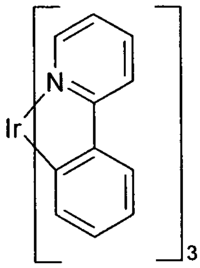

Formula (123)

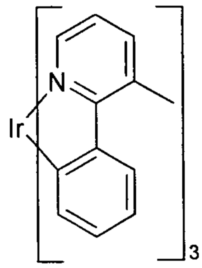

Formula (124)

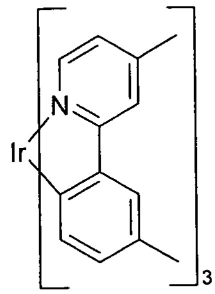

Formula (125)

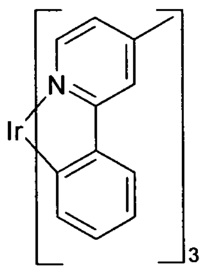

Formula (126)

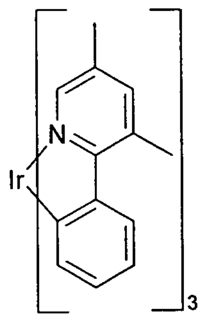

Formula (127)

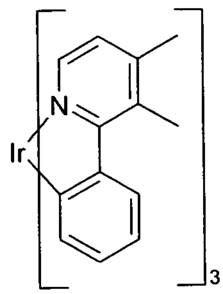

Formula (128)

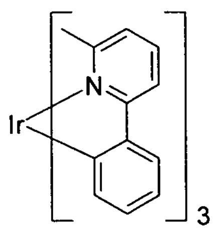

Formula (129)

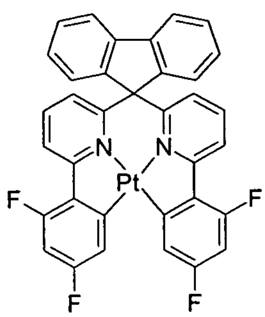

Formula (130)

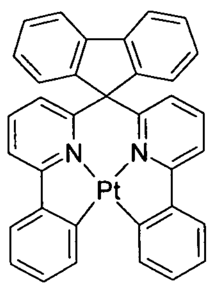

Formula (131)

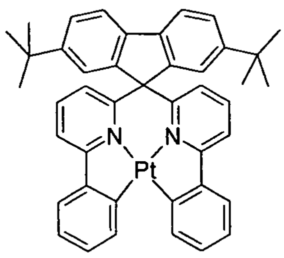
Formula (132)

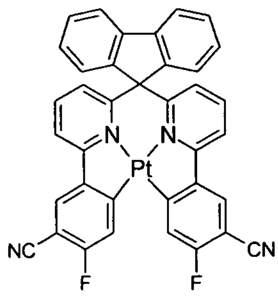
Formula (133)

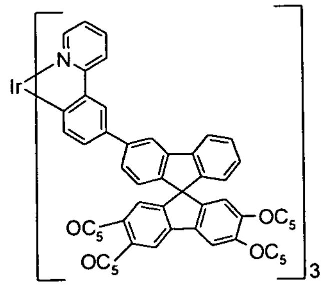
Formula (134)

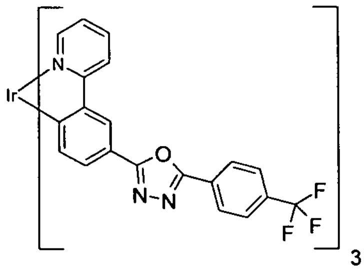
Formula (135)

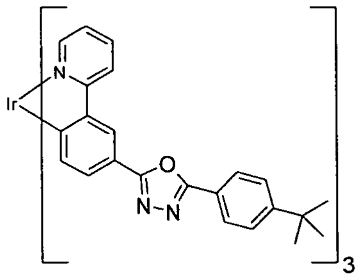
Formula (136)

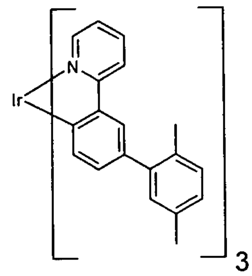
Formula (137)

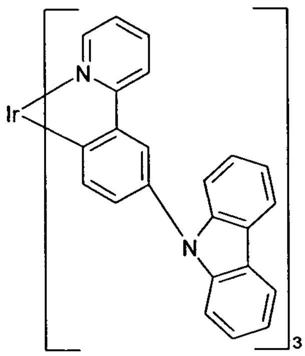
Formula (138)

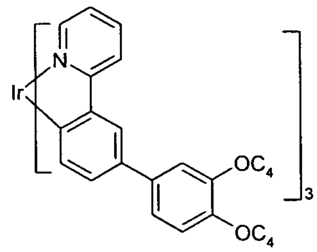
Formula (139)

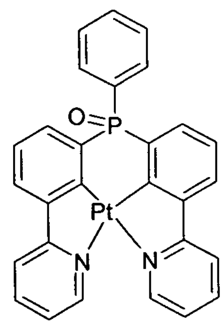
Formula (140)

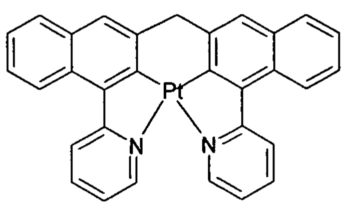
Formula (141)

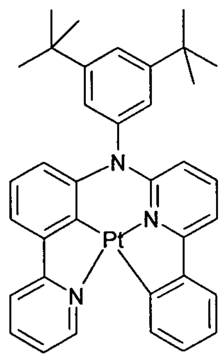
Formula (142)

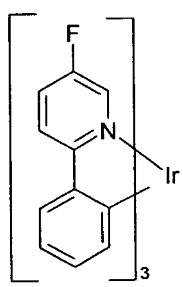
Formula (143)

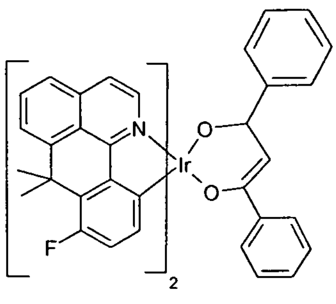

Formula (144)

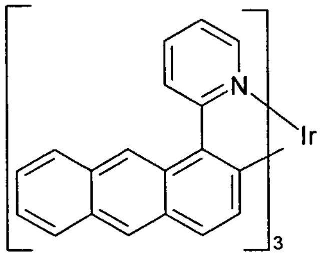

Formula (145)

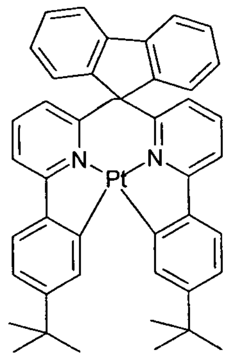

Formula (146)

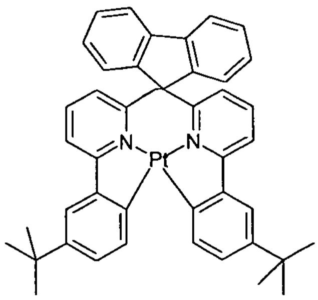

Formula (147)

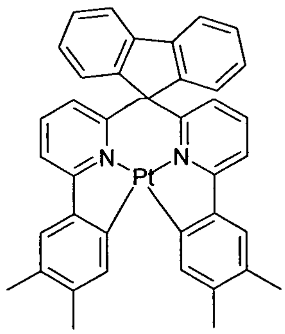

Formula (148)

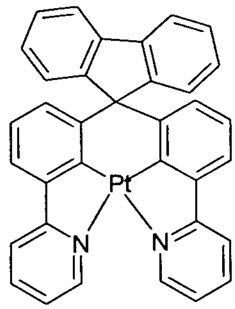

Formula (149)

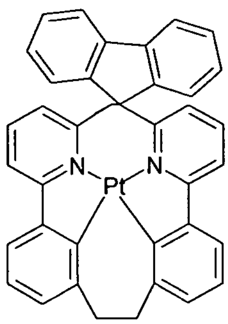

Formula (150)

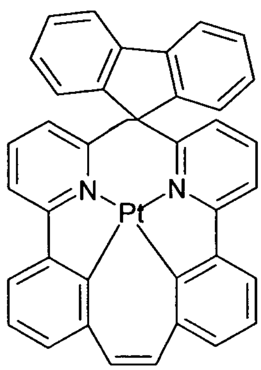

Formula (151)

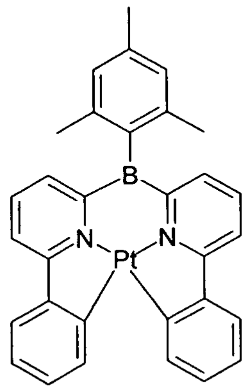

Formula (152)

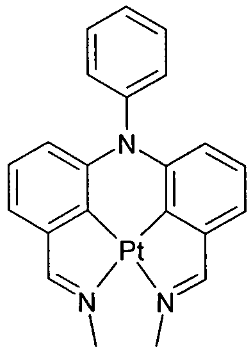

Formula (153)

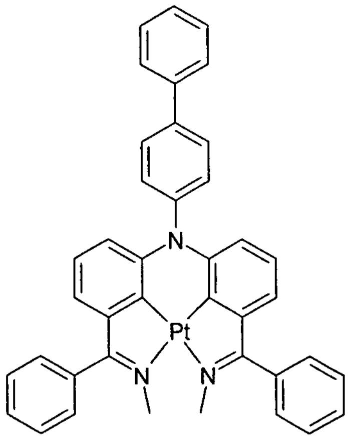

Formula (154)

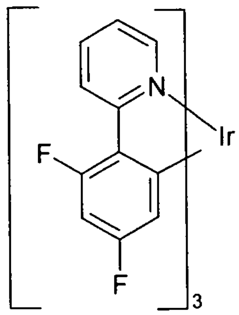

Formula (155)

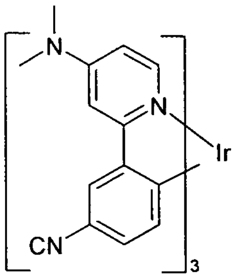

Formula (156)

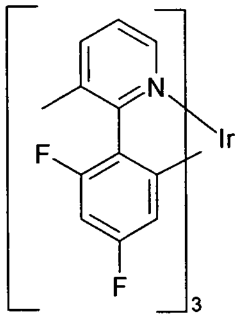

Formula (157)

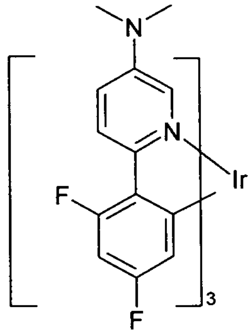

Formula (158)

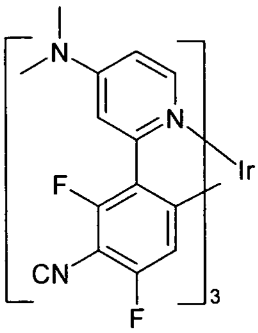

Formula (159)

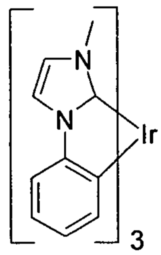

Formula (160)

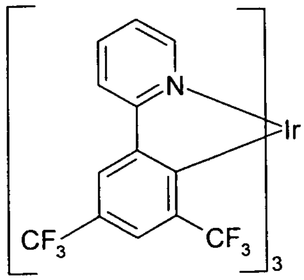

Formula (161)

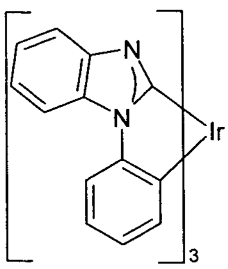

Formula (162)

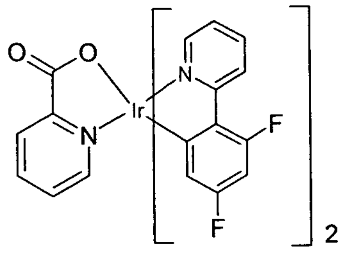

Formula (163)

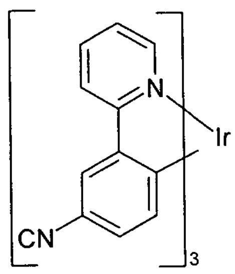

Formula (164)

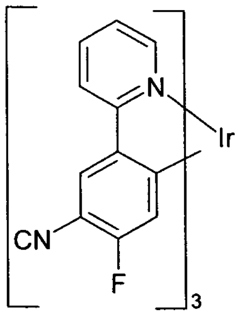

Formula (165)

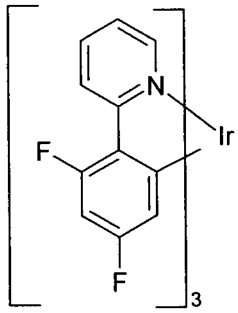

Formula (166)

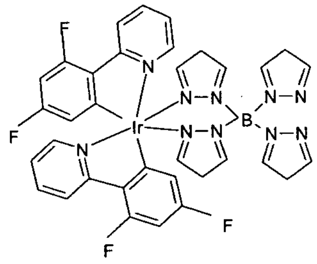

Formula (167)

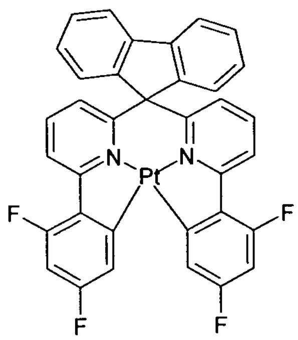

Formula (168)

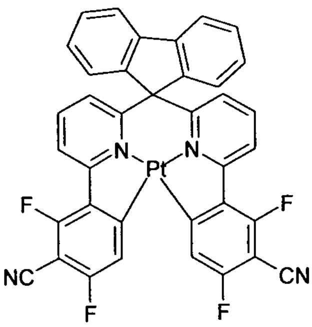

Formula (169)

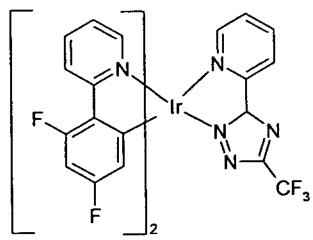

Formula (170)

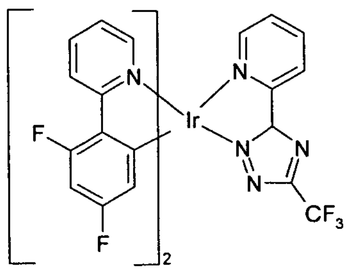

Formula (171)

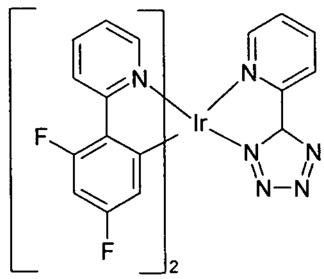

Formula (172)

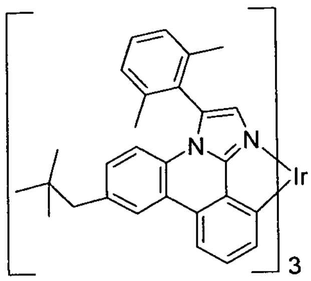

Formula (173)

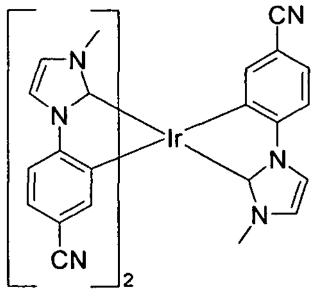

Formula (174)

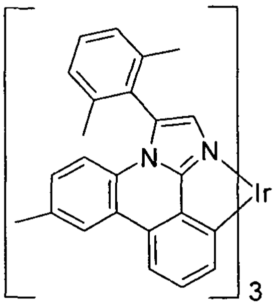

Formula (175)

The ratio of the phosphorescence emitter compound to electron transporting host compound in the active layer reaches from 0.1/99.9 to 1/1, preferably from 5/95 to 40/60, more preferably from 10/90 to 30/70, and particularly preferably fro 15/85 to 25/75 in terms of moles.

The charge transporting host compound of the electric field quenching devices according to an example, not forming part of the present invention, is an electron transporting host compound.

The term "host compound" as used in the present invention is to be understood as every compound which is able to serve as a matrix in the active layer for the phosphorescence emitter compound. In other words the main structure of the active layer is build up by an aggregation of the host compounds. The host compound is doped with the phosphorescence emitter compound, preferable by a statistic distribution.

The term "electron transporting host compound" means a host compound in the above sense which is able to transport electrons from one molecule to the next.

The lowest unoccupied molecule orbital (LUMO) of the electron transporting host compound is preferably lower than that of the said phosphorescent emitter compound.

In principle any electron transport materials (ETMs) known to one skilled in the art of OLEDs can be employed as charge transport host in active layer. The active layer, according to an example not forming part of the present invention, comprises 3, particularly preferably 2, and very particularly preferably 1 ETM(s).

The active layer may consist of an intrinsic material or comprise a dopant. $Alq_3$ (EP 278757 B1) and Liq (EP 0569827 A2) are examples of intrinsic layers. 4,7-diphenyl-1,10-phenanthroline (Bphen):Li 1:1 (US 2003/02309890) and rubrene/LiF are examples of doped layers. Suitable electron transporting host compound can be selected from imidazoles, pyridines, pyrimidines, pyridazines, pyrazines, oxadiazoles, chinolines, chinoxalines, anthracenes, benzanthracenes, pyrenes, perylenes, benzimidazoles, triazines, ketones, phosphinoxides, phenazines, phenanthrolines, triarylboranes, isomers and derivatives thereof.

Suitable compounds for electron-transport host are metal chelates of 8 hydroxyquinoline (for example Liq, $Alq_3$, $Gaq_3$, $Mgq_2$, $Znq_2$, $Inq_3$, $Zrq_4$), Balq, 4 azaphenanthrene-5-ol/Be complexes (US 5529853 A; e.g. Formula (176)), butadiene derivatives (US 4356429), heterocyclic optical brighteners (US 4539507), benzazoles, such as, for example, 1,3,5-tris(2-N-phenylbenzimidazolyl)benzene (TPBI) (US 5766779, Formula (177)), 1,3,5-triazines, pyrenes, anthracenes, tetracenes, fluorenes, spirobifluorenes, dendrimers, tetracenes, for example rubrene derivatives, 1,10-phenanthroline derivatives (JP 2003/115387, JP 2004/311184, JP 2001/267080, WO 2002/043449), silacyl-cyclopentadiene derivatives (EP 1480280, EP 1478032, EP 1469533), pyridine derivatives (JP 2004/200162 Kodak), phenanthrolines, for example BCP and Bphen, also a number of phenanthrolines bonded via biphenyl or other aromatic groups (US 2007/0252517 A1) or phenanthrolines bonded to anthracene (US 2007/0122656 A1, e.g. Formulae (178) and (179)), 1,3,4-oxadiazoles, for example Formula (180), triazoles, for example Formula (181), triarylboranes, for example also with Si, benzimidazole derivatives and other N heterocyclic compounds (cf. US 2007/0273272 A1), silacyclopentadiene derivatives, borane derivatives, Ga oxinoid complexes.

Preference is given to 2,9,10-substituted anthracenes (with 1- or 2-naphthyl and 4- or 3-biphenyl) or molecules which contain two anthracene units (US 2008/0193796 A1).

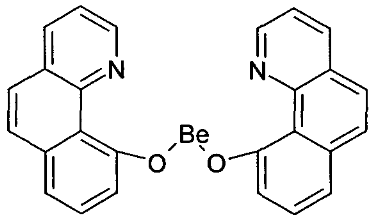

Formula (176)

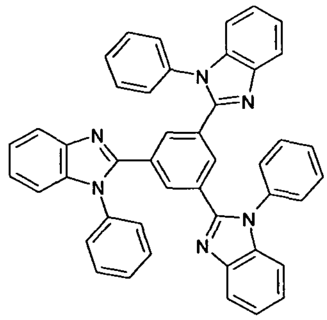

Formula (177)

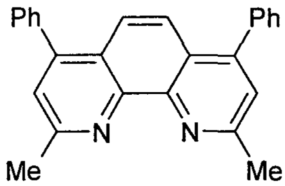

Formula (178)

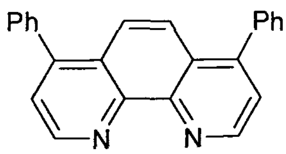

Formula (179)

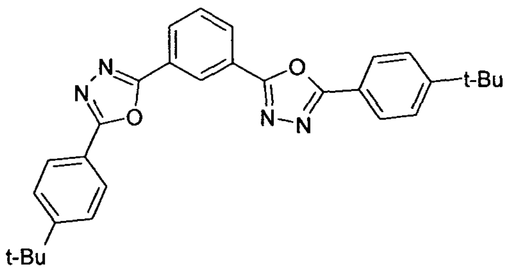

Formula (180)

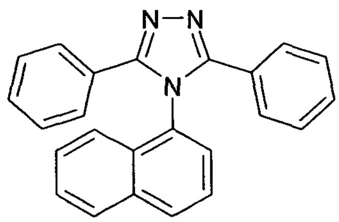

Formula (181)

Preference is likewise given to anthracene-benzimidazole derivatives, such as, for example, the compounds of Formulae (182) to (184), and as disclosed in, e.g., US 6878469 B2, US 2006/147747 A, and EP 1551206 A1.

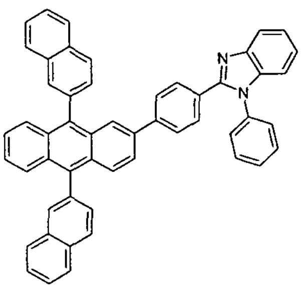

Formula (182)

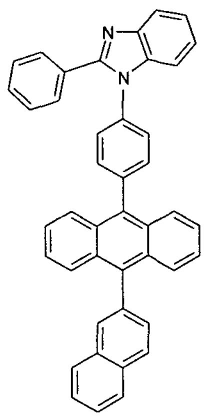

Formula (183)

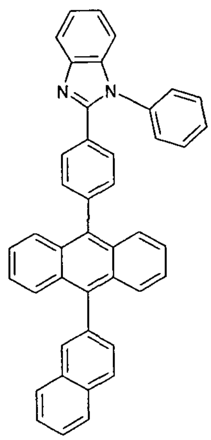

Formula (184)

Particular preference is given to ketone derivatives, such as:

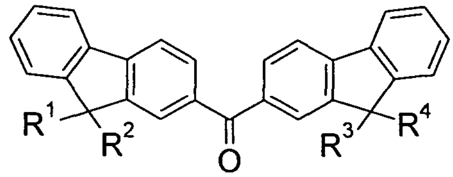

Formula (185)

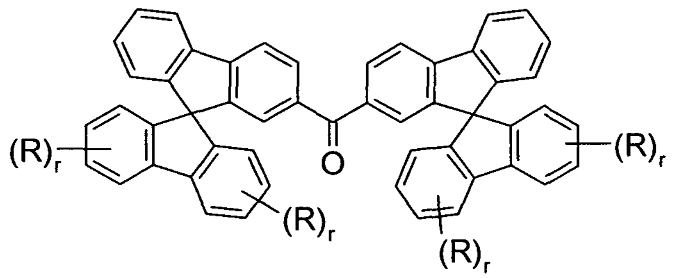

Formula (186)

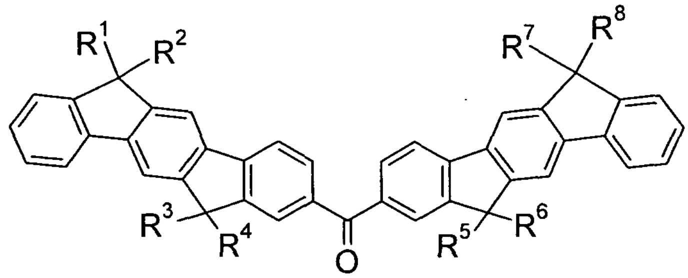

Formula (187)

wherein R and $R^1$ to $R^8$ each independently represent a hydrogen atom, a substituted or unsubstituted aromatic hydrocarbon cyclic group having 6 to 50 nuclear carbon atoms, a substituted or unsubstituted aromatic heterocyclic group having 5 to 50 nuclear atoms, a substituted or unsubstituted alkyl group having 1 to 50 carbon atoms, a substituted or unsubstituted cycloalkyl group having 3 to 50 nuclear carbon atoms, a substituted or unsubstituted alkoxy group having 1 to 50 carbon atoms, a substituted or unsubstituted aralkyl group having 6 to 50 nuclear carbon atoms, a substituted or unsubstituted aryloxy group having 5 to 50 nuclear carbon atoms, a substituted or unsubstituted arylthio group having 5 to 50 nuclear carbon atoms, a substituted or unsubstituted alkoxycarbonyl group having 1 to 50 carbon atoms, a substituted or unsubstituted silyl group 1 to 50 carbon atoms, carboxy group, a halogen atom, cyano group, nitro group or hydroxy group, optionally one or more of the pairs $R^1$ and $R^2$, $R^3$ and $R^4$, $R^5$ and $R^6$, $R^7$ and $R^8$ form a ring system, and r is 0, 1,2,3,4. The charge transporting host compounds of the present

invention are hole transporting host compounds.

The charge transporting host compounds of the first and the second.

The term "hole transporting host compound" means a host compound in the above sense which is able to transport positive charges from one molecule to the next.

Furthermore, the highest occupied molecule orbital (HOMO) of the hole transporting host compound is higher than that of the phosphorescent emitter compound.

Preferably the hole transporting host compound is selected from amines, triarylamines, thiophenes, carbazoles, phthalocyanines, porphyrines and derivatives thereof.

In principle any hole transport materials (HTMs) known to one skilled in the art of OLEDs can be employed as charge transport host in active layer of the present invention. Further to HTM mentioned elsewhere herein, HTM is preferably selected from amines, triarylamines, thiophenes, carbazoles, phthalocyanines, porphyrines, isomers and derivatives thereof. HTM is particularly preferably selected from amines, triarylamines, thiophenes, carbazoles, phthalocyanines, and porphyrines.

Preferably the active layer of the present invention comprises 3, particularly preferably 2, and very particularly preferably 1 HTM(s).

Suitable materials for hole-transporting host compound are phenylenediamine derivatives (US 3615404), arylamine derivatives (US 3567450), amino-substituted chalcone derivatives (US 3526501), styrylanthracene derivatives (JP A 56-46234), polycyclic aromatic compounds (EP 1009041), polyarylalkane derivatives (US 3615402), fluorenone derivatives (JP A 54-110837), hydrazone derivatives (US 3717462), stilbene derivatives (JP A 61-210363), silazane derivatives (US 4950950), polysilanes (JP A 2-204996), aniline copolymers (JP A 2-282263), thiophene oligomers, polythiophenes, PVK, polypyrroles, polyanilines and further copolymers, porphyrin compounds (JP A 63-2956965),

aromatic dimethylidene-type compounds, carbazole compounds, such as, for example, CDBP, CBP, mCP, aromatic tertiary amine and styrylamine compounds (US 4127412), and monomeric triarylamines (US 3180730). Even more triarylamino groups may also be present in the molecule.

Preference is given to aromatic tertiary amines containing at least two tertiary amine units (US 4720432 and US 5061569), such as, for example, 4,4'-bis[N-(1-naphthyl)-N-phenylamino]biphenyl (NPD) (US 5061569) or MTDATA (JP A 4-308688), N,N,N',N'-tetra(4-biphenyl)diaminobiphenylene (TBDB), 1,1-bis(4-di-p-tolylaminophenyl)cyclohexane (TAPC), 1,1-bis(4-dip-tolylaminophenyl)-3-phenylpropane (TAPPP), 1,4-bis[2-[4-[N,N-di(p-tolyl)amino]phenyl]vinyl]benzene (BDTAPVB), N,N,N',N'-tetra-p-tolyl-4,4'-diaminobiphenyl (TTB), TPD, N,N,N',N'-tetraphenyl-4,4'''-diamino-1,1':4',1":4",1'''-quaterphenyl, likewise tertiary amines containing carbazole units, such as, for example, 4 (9H-carbazol-9-yl)-N,N-bis[4-(9H-carbazol-9-yl)phenyl]benzeneamine (TCTA). Preference is likewise given to hexaazatriphenylene compounds in accordance with US 2007/0092755 A1.

Particular preference is given to the following triarylamine compounds of the Formulae (188) to (193), which may also be substituted, and as disclosed in EP 1162193 A1, EP 650955 A1, Synth. Metals 1997, 91(1-3), 209, DE 19646119 A1, WO 2006/122630 A1, EP 1860097 A1, EP 1834945 A1, JP 08053397 A, US 6251531 B1, and WO 2009/041635.

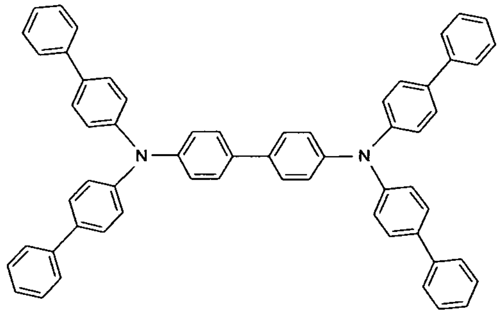

Formula (188)

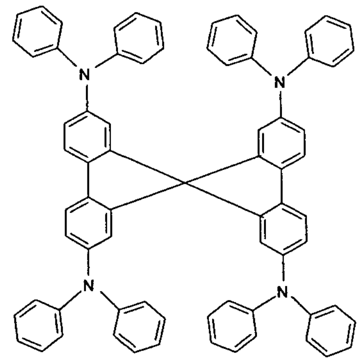

Formula (189)

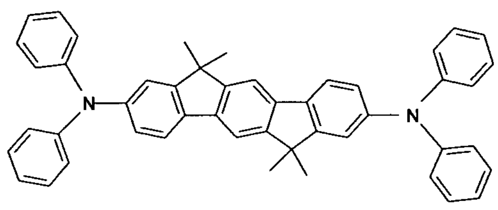

Formula (190)

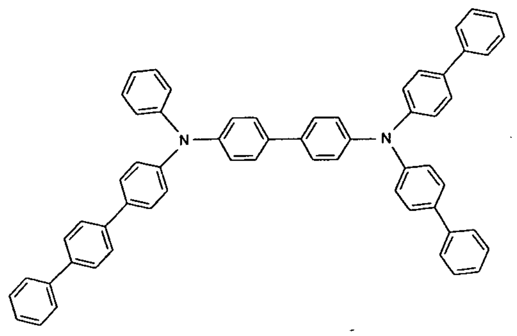

Formula (191)

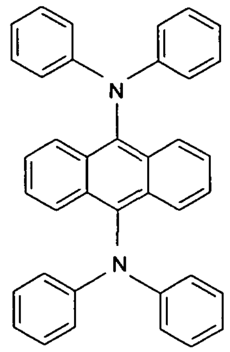

Formula (192)

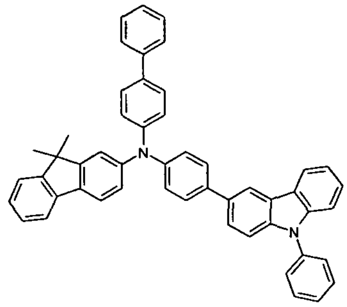

Formula (193)

In a very preferred embodiment, the said charge transport host compound has a higher triplet level (T1) than the phosphorescent emitter. In this embodiment, the charge transport host compound can be further preferably selected from the matrix or host materials which is known to the skilled one in the art of phosphorescent OLEDs. The suitable host compounds for this embodiment are selected from ketones, carbazoles, indolocarbazoles, triarylamines, indenofluorenes, fluorenes, spirobifluorenes, phenathrenes, dehydrophenanthrenes, thiophenes, triazines, imidazoles and their derivatives. Some preferred derivatives are described below in more details.

Preferred host compounds are N,N-biscarbazolylbiphenyl (CBP), carbazole derivatives (for example in accordance with WO 2005/039246, US 2005/0069729, JP 2004/288381, EP 1205527 or DE 102007002714), azacarbazoles (for example in accordance with EP 1617710, EP 1617711, EP 1731584, JP 2005/347160), ketones (for example in accordance with WO 2004/093207), phosphine oxides, sulfoxides and sulfones (for example in accordance with WO 2005/003253), oligophenylenes, aromatic amines (for example in accordance with US 2005/0069729), bipolar matrix materials (for example in accordance with WO 2007/137725), silanes (for example in accordance with WO 2005/111172), 9,9-diarylfluorene derivatives (e.g. in accordance with DE 102008017591), azaboroles or boronic esters (for example in accordance with WO 2006/117052), triazole derivatives, oxazoles and oxazole derivatives, imidazole derivatives, polyarylalkane derivatives, pyrazoline derivatives, pyrazolone derivatives, distyrylpyrazine derivatives, thiopyran dioxide derivatives, phenylenediamine derivatives, tertiary aromatic amines, styrylamines, indoles, anthrone derivatives, fluorenone derivatives, fluorenylidenemethane derivatives, hydrazone derivatives, silazane derivatives, aromatic dimethylidene compounds, porphyrin compounds, carbodiimide derivatives, diphenylquinone derivatives, phthalocyanine derivatives, metal complexes of 8 hydroxyquinoline derivatives, such as, for example, $Alq_3$, the 8 hydroxyquinoline complexes may also contain triarylaminophenol ligands (US 2007/0134514 A1), various metal complex-polysilane compounds with metal phthalocyanine, benzoxazole or benzothiazole as ligand, hole-conducting polymers, such as, for example, poly(N-vinylcarbazole) (PVK), aniline copolymers, thiophene oligomers, polythiophenes, polythiophene derivatives, polyphenylene derivatives, polyfluorene derivatives.

Further particularly preferred host compounds are selected from compounds comprising indolocarbazoles and their derivatives (e.g. Formulae (194) to (200)), as disclosed for examples in DE 102009023155.2, EP 0906947B1, EP 0908787B1, EP 906948B1, WO 2008/056746A1, WO 2007/063754A1, WO 2008/146839A1, and WO 2008/149691A1.

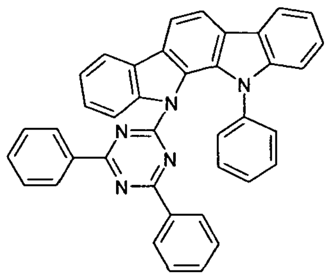

Formula (194)

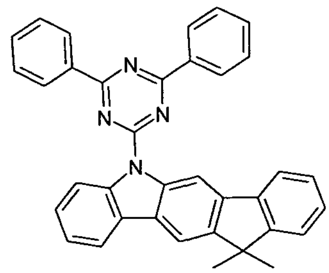

Formula (195)

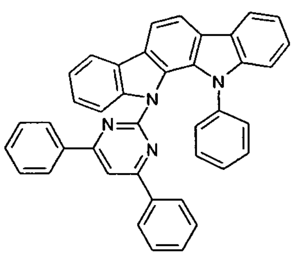

Formula (196)

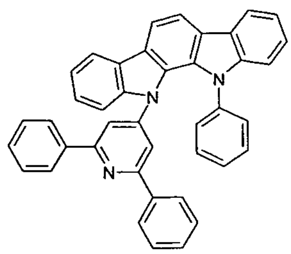

Formula (197)

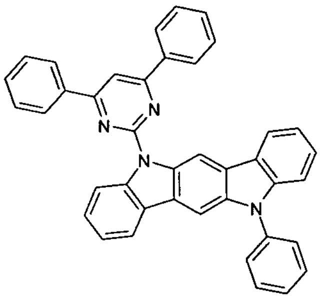

Formula (198)

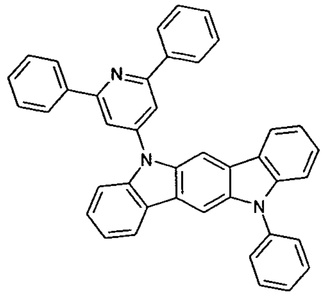

Formula (199)

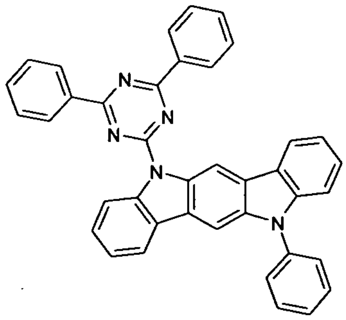

Formula (200)

Examples of preferred carbazole derivatives are, 1,3-N,N-dicarbazolebenzene (= 9,9'-(1,3-phenylene)bis-9H-carbazole) (mCP), 9,9'-(2,2'-dimethyl[1,1'-biphenyl]-4,4'-diyl)bis-9H-carbazole (CDBP), 1,3-bis(N,N'-dicarbazole)benzene (= 1,3-bis(carbazol-9-yl)benzene), PVK (polyvinylcarbazole), 3,5-di(9H-carbazol-9-yl)biphenyl and compounds of the Formulae (201) to (205).

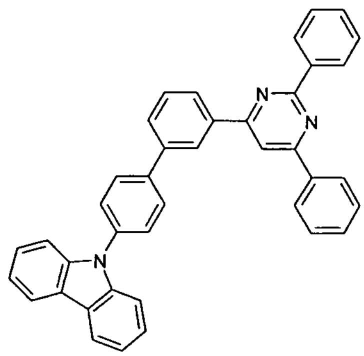

Formula (201)

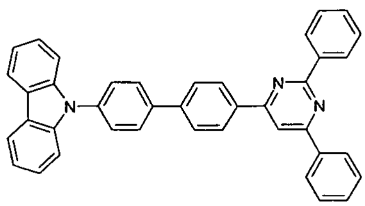

Formula (202)

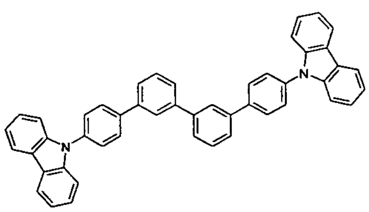

Formula (203)

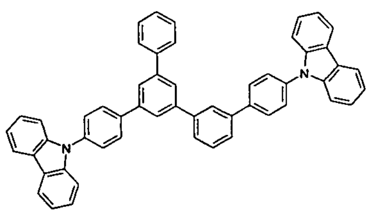

Formula (204)

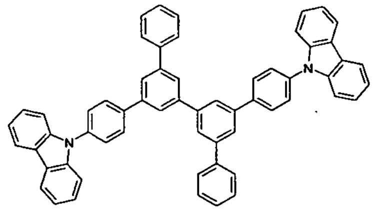

Formula (205)

A further preferred host compound is the compound of Formula (206) (EP 652273 B1)

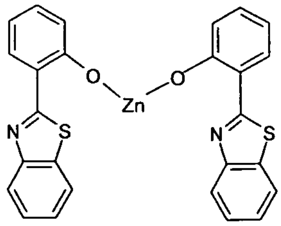

Formula (206)

Further particularly preferred host compounds are selected from compounds of the general Formula (207) (EP 1923448A1).

$[M(L)_2]_n$ Formula (207)

wherein M, L, and n are defined as in the reference. Preferably M is Zn, and L is quinolinate, and n is 2, 3 or 4. Very particularly preferred are $[Znq_2]_2$, $[Znq_2]_3$, and $[Znq_2]_4$.

Co-hosts selected from metal oxinoid complexes whereby lithium quinolate (Liq) or $Alq_3$ can be used in an example not forming part of the present invention.

In an example, not forming part of the present invention, the host of the active layer has a dominated electron transport property, which can be realized by including in the active layer only electron transport host compound(s) as described above and below.

According to the present invention, the host of the active layer has a dominated hole transport property, which is realized by including in the active layer only hole transport host compound(s) as described above and below.

The host of the active layer of the present invention can be in form of small molecule, oligomer, dendrimer, polymer and blend or mixture thereof. The term small molecule as used herein is defined as molecule not being a polymer, oligomer, dendrimer, or a blend. In particular, repeating structures are absent in small molecules. The molecular weight of small molecules is typically in the range of polymers with a low number of repeating units, oligomers or less.

The molecular weight of the small molecule is preferably below 4000 g/mol, particularly preferably below 3000 g/mol, and very particularly preferably below 2000 g/mol.

The polymers of the present invention preferably have 10 to 10000, particularly preferably 20 to 5000 and very particularly preferably 50 to 2000 repeat units. Oligomers according to this invention have preferably 2 to 9 repeat units. The branching index of the polymers and oligomers is between 0 (linear polymer without branching) and 1 (completely branched dendrimer). The term dendrimer as used herein is defined according to M. Fischer et al. in Angew. Chem., Int. Ed. 1999, 38, 885).

The molecular weight (MW) of the polymers is in the range of 10000 to 2000000 g/mol, particularly preferably in the range of 100000 to 1500000 g/mol, and very particularly preferably in the range of 200000 to 1000000 g/mol. The determination of MW can be performed according to standard techniques known to the person skilled in the art by employing gel permeation chromatography (GPC) with polystyrene as internal standard, for instance.

In a particularly preferred embodiment, the host of the present invention is selected from small molecules (SM) comprising the charge transport compound as described above.

In another preferred embodiment, the host of the present invention is selected from polymeric compounds, which comprises the charge transport compound as described above as repeating unit(s). Very preferably, the host is a conjugated polymer.

The active layer of the FQD according to the present invention may further comprise at least one emitter

compound, which may be preferably selected from organic phosphorescent emitters, organic fluorescent emitter and colloidal quantum dots.

In a very preferred embodiment, the emission spectrum of the first phosphorescent emitter overlaps with the absorption spectrum of the further emitter compound(s). In this embodiment, the energy is transferred in a cascade process: exciting light → the first phosphorescent emitter → the further emitter compound(s). By quenching the emission from the first phosphorescent emitter, the overall photoluminescence will be quenched.

In another very preferred embodiment, the absorption spectrum of the first phosphorescent emitter overlaps with the emission spectrum of at least one of the further emitter compound(s).

Suitable phosphorescent emitter for the further emitter compound can be preferably selected from the organometal complexes as described above.

Suitable organic fluorescent emitter for the further emitter compound can be preferably selected from the emitter compounds which is known to the skilled one in the art of OLEDs. The preferred organic fluorescent emitter compounds are described below.

Blue fluorescent emitters are preferably polyaromatic compounds, such as, for example, 9,10-di(2-naphthylanthracene) and other anthracene derivatives, derivatives of tetracene, xanthene, perylene, such as, for example, 2,5,8,11-tetra-t-butylperylene, phenylene, for example 4,4'-(bis(9-ethyl-3-carbazovinylene)-1,1'-biphenyl, fluorene, arylpyrenes (US 2006/0222886), arylenevinylenes (US 5121029, US 5130603), derivatives of rubrene, coumarine, rhodamine, quinacridone, such as, for example, N,N'-dimethylquinacridone (DMQA), dicyanomethylenepyrane, such as, for example, 4 (dicyanoethylene)-6-(4-dimethylaminostyryl-2-methyl)-4H-pyrane (DCM), thiopyrans, polymethine, pyrylium and thiapyrylium salts, periflanthene, indenoperylene, bis(azinyl)imine-boron compounds (US 2007/0092753 A1), bis(azinyl)methene compounds and carbostyryl compounds.

Further preferred blue fluorescent emitters are described in C.H. Chen et al.: "Recent developments in organic electroluminescent materials" Macromol. Symp. 125, (1997), 1-48 and "Recent progress of molecular organic electroluminescent materials and devices" Mat. Sci. and Eng. R, 39 (2002), 143-222.

Preferred fluorescent emitters are selected from the class of the mono-styrylamines, the distyrylamines, the tristyrylamines, the tetrastyrylamines, the styrylphosphines, the styryl ethers and the arylamines.

A monostyrylamine is taken to mean a compound which contains one substituted or unsubstituted styryl group and at least one, preferably aromatic, amine. A distyrylamine is taken to mean a compound which contains two substituted or unsubstituted styryl groups and at least one, preferably aromatic, amine. A tristyrylamine is taken to mean a compound which contains three substituted or unsubstituted styryl groups and at least one, preferably aromatic, amine. A tetrastyrylamine is taken to mean a compound which contains four substituted or unsubstituted styryl groups and at least one, preferably aromatic, amine. The styryl groups are particularly preferably stilbenes, which may also be further substituted. The corresponding phosphines and ethers are defined analogously to the amines. For the purposes of this invention, an arylamine or an aromatic amine is taken to mean a compound which contains three substituted or unsubstituted aromatic or heteroaromatic ring systems bonded directly to the nitrogen. At least one of these aromatic or heteroaromatic ring systems is preferably a condensed ring system, preferably having at least 14 aromatic ring atoms. Preferred examples thereof are aromatic anthracene-amines, aromatic anthracene-diamines, aromatic pyrene-amines, aromatic pyrene-diamines, aromatic chrysene-amines and aromatic chrysene-diamines. An aromatic anthracene-amine is taken to mean a compound in which one diarylamino group is bonded directly to an anthracene group, preferably in the 9 position. An aromatic anthracene-diamine is taken to mean a compound in which two diarylamino groups are bonded directly to an anthracene group, preferably in the 9,10-position. Aromatic pyrene-amines, pyrene-diamines, chrysene-amines and chrysene-diamines are defined analogously thereto, where the diarylamino groups on the pyrene are preferably bonded in the 1 position or in the 1,6-position.

Further preferred fluorescent emitters are selected from indenofluorene-amines and indenofluorene-diamines, for example in accordance with WO 2006/122630, benzoindenofluorene-amines and benzoindenofluorene-diamines, for example in accordance with WO 2008/006449, and dibenzoindenofluorene-amines and dibenzoindenofluorene-diamines, for example in accordance with WO 2007/140847.

Examples of emitters from the class of the styrylamines are substituted or unsubstituted tristilbene-amines or the emitters described in WO 2006/000388, WO 2006/058737, WO 2006/000389, WO 2007/065549 and WO 2007/115610. Distyrylbenzene and distyryl-biphenyl derivatives are described in US 5121029. Further styrylamines are found in US 2007/0122656 A1.

Particularly preferred styrylamine emitters and triarylamine emitters are the compounds of the Formulae (208) to (213) and as disclosed in US 7250532 B2, DE 102005058557 A1, CN 1583691 A, JP 08053397 A, US 6251531 B1, and US 2006/210830 A.

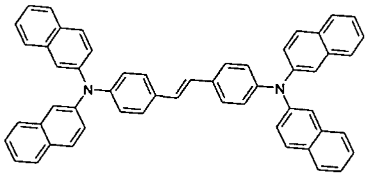

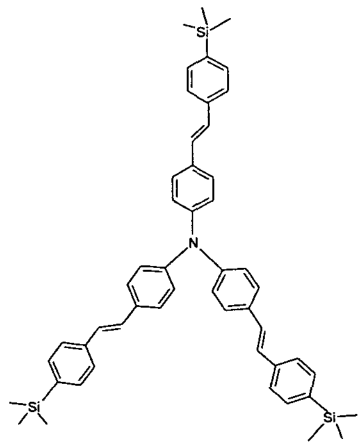

Formula (208) Formula (209)

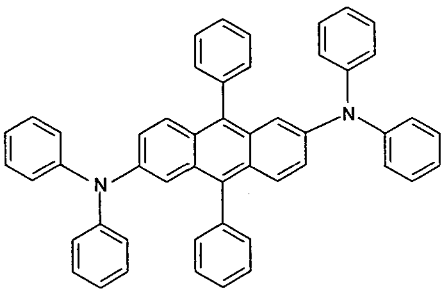

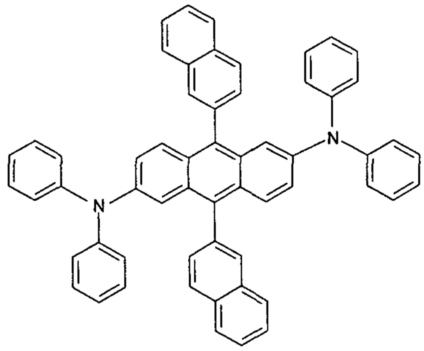

Formula (210) Formula (211)

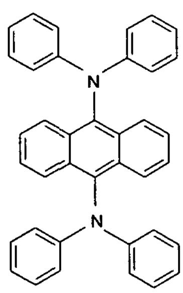

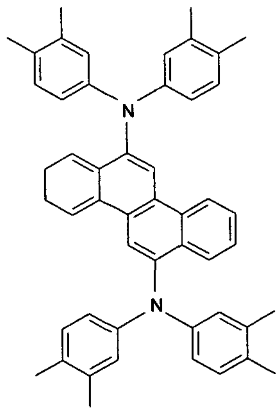

Formula (212) Formula (213)

Further preferred fluorescent emitters are selected from the group of triarylamines as disclosed in EP 1957606 A1and US 2008/0113101 A1.

Further preferred fluorescent emitters are selected from derivatives of naphthalene, anthracene, tetracene, fluorene, periflanthene, indenoperylene, phenanthrene, perylene (US 2007/0252517 A1), pyrene, chrysene, decacyclene, coronene, tetraphenylcyclopentadiene, pentaphenylcyclopentadiene, fluorene, spirofluorene, rubrene, coumarine (US 4769292, US 6020078, US 2007/0252517 A1), pyran, oxazone, benzoxazole, benzothiazole, benzimidazole, pyrazine, cinnamic acid esters, diketopyrrolopyrrole, acridone and quinacridone (US 2007/0252517 A1).

Of the anthracene compounds, particular preference is given to 9,10-substituted anthracenes, such as, for

example, 9,10-diphenylanthracene and 9,10-bis(phenylethynyl)anthracene. 1,4-Bis(9'-ethynylanthracenyl)-benzene is also a preferred emitter.

In a further preferred embodiment, the active layer further comprises an emitter compound selected from emissive quantum dots.

In general, a quantum dot is a semiconductor whose excitons are confined in all three spatial dimensions. As a result, they have properties that are between those of bulk semiconductors and those of discrete molecules. There are several ways to make quantum dot structures, for example by chemical methods or by ion implantation, or in nanodevices made by state-of-the-art lithographic techniques.

The quantum dots (QDs) suitable for the present invention refers to colloidal semiconductor nanocrystals, also known as Colloidal quantum dots, or nanodots or nanocrystals, which are produced by chemical methods.

While any method known to the skilled person can be used to create QDs, preferably, a solution-phase colloidal method for controlled growth of inorganic QDs is used. The said colloidal methods can be referred to for, example, Alivisatos, A. P., "Semiconductor clusters, nanocrystals, and quantum dots," Science 271:933 (1996); X. Peng, M. Schlamp, A. Kadavanich, A. P. Alivisatos, "Epitaxial growth of highly luminescent CdSe/CdS Core/Shell nanocrystals with photostability and electronic accessibility," J. Am. Chem. Soc. 30:7019-7029 (1997); and C. B. Murray, D. J. Norris, M. G. Bawendi, "Synthesis and characterization of nearly monodisperse CdE (E=sulfur, selenium, tellurium) semiconductor nanocrystallites," J. Am. Chem. Soc. 115:8706 (1993). These methods allow low cost processability without the need for clean rooms and expensive manufacturing equipment.

The suitable semiconducting materials, which can be incoporated into QDs, are selected from elements of Group II- VI, such as CdSe, CdS, CdTe, ZnSe, ZnO, ZnS, ZnTe, HgS, HgSe, HgTe and alloys thereof such as CdZnSe; Group III-V, such as InAs, InP, GaAs, GaP, InN, GaN, InSb, GaSb, AlP, AlAs, AlSb and alloys such as InAsP, CdSeTe, ZnCdSe, InGaAs; Group IV-VI, such as PbSe, PbTe and PbS and alloys thereof; Group III- VI, such as InSe, InTe, InS, GaSe and alloys such as InGaSe, InSeS; Group IV semiconductors, such as Si and Ge alloys thereof, and combinations thereof in composite structures.

Further suitable semiconductor materials include those disclosed in U.S. patent application Ser. No. 10/796,832 and include any type of semiconductor, including group II-VI, group III-V, group IV-VI and group IV semiconductors. Suitable semiconductor materials include, but are not limited to, Si, Ge, Sn, Se, Te, B, C (including diamond), P, BN, BP, BAs, AlN, AlP, AlAs, AlSb, GaN, GaP, GaAs, GaSb, InN, InP, InAs, InSb, AlN, AlP, AlAs, AlSb, GaN, GaP, GaAs, GaSb, ZnO, ZnS, ZnSe, ZnTe, CdS, CdSe, CdTe, HgS, HgSe, HgTe, BeS, BeSe, BeTe, MgS, MgSe, GeS, GeSe, GeTe, SnS, SnSe, SnTe, PbO, PbS, PbSe, PbTe, CuF, CuCl, CuBr, CuI, $Si_3N_4$, $Ge_3N_4$, $Al_2O_3$, (Al, Ga, In)2 (S, Se, Te)3, $Al_2CO$, and an appropriate combination of two or more such semiconductors.

In some embodiments, the QDs may comprise a dopant from the group consisting of: a p-type dopant or an n-type dopant. The properties and synthesis of a doped QD can be referred to "n-type colloidal semiconductor nanocrystals" by Moonsub Shim & Philippe Guyot-Sionnest, Nature vol407 (2000) p981, and "Doped Nanocrystals" by Norris et al., Science, 319 (2008), p1776. The QDs the present invention can also comprise II-VI or III-V semiconductors. Examples of II-VI or III-V semiconductor nanocrystals include any combination of an element from Group II, such as Zn, Cd and Hg, with any element from Group VI, such as S, Se, Te, Po, of the Periodic Table; and any combination of an element from Group III, such as B, Al, Ga, In, and Tl, with any element from Group V, such as N, P, As, Sb and Bi, of the Periodic Table.

In a very preferred embodiment, the quantum dots has a core/shell structure, which can eliminate the non-radiative decay channel originating from surface electronic states, and thus leading to high photo-luminescence, as dislcosed by X. Peng, et al., J. Am. Chem. Soc. 30:7019-7029 (1997). In a preferred embodiment, ZnS can be used as the shell material using known synthetic processes.

In a particularly preferred embodiment, the QD of the invention comprises semiconducting materials selected from Group II- VI semiconductors, alloys thereof and core/shell structures made there from. In further embodiments, the Group II-VI semiconductors are CdSe, CdS, CdTe, ZnSe, ZnS, ZnTe, alloys thereof, combinations thereof and core/shell, core multi-shell layered-structures thereof.

The electric field quenching device of the present invention may further comprise a substrate, which is preferably a transparent substrate. The substrate is preferably a substrate made of glass, films or foils based on polymers or plastics. The main selection criteria for polymers or plastics is glass transition temperature. The glass temperature ($T_g$) of the polymers can be found in a common handbooks, e.g. in "Polymer Handbook", Eds. J. Brandrup, E. H. Immergut, and E. A. Grulke, John Willey & Sons, Inc., 1999, VI/193-VI/276. Preferably, the $T_g$ of the polymer is above 100°C, particularly preferably above 150°C, and very particularly preferably above 180°C. Very preferred substrates are for example, poly(ethylene terephthalate) (PET) and poly(ethylene 2,6-naphthalate) (PEN). Any kind of material may be used as substrate as long as it is possible to arrange one of the electrodes, preferably as an electrode layer, on the substrate. One preferably arrangement is therefore: substrate, first electrode, active layer, second electrode. Between the electrodes and the active layer, the electric field quenching device of the present invention may further contain another layers, such as an electron transporting layer, a hole transporting layer. It is also possible that the electric field

quenching device may not contain a substrate, but is used as it is without substrate in a display and may be hold therein by other means.

According to the invention, the FQD comprising three electrodes is characterized in that there is an insulating layer between the third electrode and the active layer. In principle any insulating material can be employed.

In a very preferred embodiment, the insulating layer comprises material, which can be used in dielectric layer in organic field-effect transistors (OFETs). The suitable materials are described below. The insulating layer preferably comprises a fluoropolymer, like e.g. the commercially available Cytop 809M® or Cytop 107M® (from Asahi Glass). Preferably the gate insulator layer is deposited, e.g. by spin-coating, doctor blading, wire bar coating, spray or dip coating or other known methods, from a formulation comprising an insulator material and one or more solvents with one or more fluoro atoms (fluorosolvents), preferably a perfluorosolvent. A suitable perfluorosolvent is e.g. FC75® (available from Acros, catalogue number 12380). Other suitable fluoropolymers and fluorosolvents are known in prior art, like for example the perfluoro-polymers Teflon AF® 1600 or 2400 (from DuPont) or Fluoropel® (from Cytonix) or the perfluorosolvent FC 43® (Acros, No. 12377). Especially preferred are organic dielectric materials having a low permittivity (or dielectric contant) from 1.0 to 5.0, very preferably from 1.8 to 4.0 ("low *k* materials"), as disclosed for example in US 2007/0102696 A1 or US 7095044.

In a further preferred embodiment, the insulating layer comprises inorganic insulating material, which can be metal oxides or mixed oxides or others, for example $SiO_x$, $SiN_x$, $AlO_x$, $ZrO_x$, $ZnO_x$, $HfO_x$, $TiO_x$.

The thickness of the insulating layer of the FQD according to the present invention can vary from 1 nm to 1 $\mu$m, preferably from 5 nm to 0.5 $\mu$m, very preferably from 50 nm to 0.5 $\mu$m, particularly preferably from 100 nm to 0.5 $\mu$m.

The thickness of the active layer of the FQD according to the present invention can vary from 10 nm to 100 $\mu$m, preferably from 50 nm to 50 $\mu$m, very preferably from 60 nm to 20 $\mu$m, particularly preferably from 60 nm to 5 $\mu$m.

The active layer of the electric field quenching device of the present invention is preferably formed in that a solution comprising at least the phosphorescent emitter compound and the charge transporting host compound in a solvent is applied to a support, and the solvent is subsequently removed. If one of the electrodes is in the form of an electrode layer the electrode layer may be formed in the same way as the active layer.

Another possibility to apply any kind of layers of the present invention to a substrate or former layers on the substrate is to use a sublimation method. Thereby the materials are vapor-deposited in vacuum sublimation devices at a pressure of less than $10^{-5}$ mbar, preferably less than $10^{-6}$ mbar, more preferred less than $10^{-7}$ mbar. Furthermore, it is possible to apply one or more layer with the so-called OVPD-(organic vapor phase deposition)-method or with the aid of sublimation by a carrier gas. Thereby, the materials will be applied by a pressure between $10^{-5}$ mbar and 1 bar. A special case of these methods is the so-called OVJP-(organic vapor jet printing)-method wherein the materials are applied by a nozzle (for instance M. S. Arnold et al., Appl. Phys. Lett. 2008, 92, 053301).

It is, however, preferred that one or more layers of the electric field quenching device is applied from solution, for instance by means of spin coating or any kind of printing method, such as, but without limitation, dip coating, spin coating, ink jet printing, letter-press printing, screen printing, doctor blade coating, roller printing, reverse-roller printing, offset lithography printing, flexographic printing, web printing, spray coating, brush coating or pad printing, slot-die coating.. Especially preferred is screen printing, spray coating, offset lithography printing, and inkjet printing. These methods are generally known by the skilled person in the art and may be applied without problems to any kind of electric field quenching devices.

One of the electrodes is usually negatively biased, also called cathode and the other positively biased, also called anode. The electrodes (cathode, anode) according to this invention are preferably chosen in a favor that only one kind of charge carrier can flow through the active layer, or one kind of charge carrier is dominated in the active layer in comparison with the other one. In an example not forming part of the present invention, wherein the active layer comprises electron transport host compound(s), and more preferably only electron transport host compound(s), the anode is preferably selected from a conducting materials, whose electron affinity is higher than the LUMO of the electron transport host compound(s); and further preferably, the cathode is able to inject electron into the active layer.

According to the present invention, wherein the active layer comprises only hole transport host compound(s), the cathode is selected from a conducting materials, whose electron affinity is lower than the HOMO of the hole transport host compound(s); and further preferably, the anode is able to inject hole into the active layer.

The conductive material with a low electron affinity can be selected from a metal complex, a metal with a low electron affinity, a metal alloy or a multilayered structure of different metals, such as alkali metals, earth alkali metals, main group metals or lanthanides (such as Ca, Ba, Mg, Al, In, Mg, Yb, Sn, and so on). If the structure is a multilayered structure, in addition to the mentioned metals further metals may be used which have a high electron affinity, such as Ag, whereas then normally combinations of metals, such as Ca/Ag or Ba/Ag are used. It may further be preferred to place between a metallic cathode and the organic semiconductor a thin interlayer of materials with a high dielectric constant. As such materials are for instance used alkali metal fluorides or earth alkali metal fluorides, but also the respective oxides (such as LiF, $Li_2O$, $BaF_2$, MgO, NaF, an so on). The thickness of this layer is preferably between 1 and 10 nanometers, more preferably between 2 to 8 nanometers.

The conductive material with a high electron effinity can be selected from a metal with high electron affinity such as Ag, Pt or Au. Furthermore, electrodes made from metal/metal oxides (such as Al/Ni/$NiO_x$, Al/$PtO_x$) may be used. For some applications at least one of the electrodes should be transparent, in order to allow the irradiation of the organic material or the out-coupling of light. Furthermore, it is preferred that the anode is made of a transparent material. Electrode materials of this kind are preferably conductive mixed metal oxides. Especially preferred are indium-tin oxide (ITO) or indium - furthermore preferred are conductive, doped organic materials, in particular conductive doped polymers.

According to the invention the third electrode is presented. In general any conductive materials can be employed as the third electrode. Very preferably, the third electrode is transparent. The third electrode has one similar function as the gate electrode as OFETs, It can improve or hinder the conducting channel between the active layer and the insulating layer. For example, not according to the invention, where the active layer (only) comprise electron transport host compound(s), a positive bias on the third electrode will improve the conducting channel, whereas a negative bias will hinder the conducting channel. Another function of the third electrode of the field-quenching device according to the present invention is that it can provide an additional electric field normal to the active layer, which may help to increase the probability of the dissociation of the excitons upon optical excitation.

The electrodes of the electric field quenching devices of the present invention are made of materials which allow to drive a voltage to the device.

Another embodiment of the present invention is a process for controlling and/or regulating photoluminescence as described in claim 8.

In other words the electric field quenching device according to the present invention is characterized in that more than 50%, more preferably more than 60%, very preferably more than 70%, particularly more than 90% photoluminescence of active layer is quenched, if a voltage is applied at one of the at least two electrodes.

There are several ways to applying optical excitation. The first one, is to expose the active layer through the transparent substrate and transparent electrode by shining an extern light source on the device. The second way is to pump the light from the edge of the substrate, and light propagates by the wave-guide mode of the substrate to the area of the active layer.

A further embodiment of the present invention is a display as described in claim 7. The display is preferably a display which is able to show light in the colors all over the entire visible spectrum. That is, the display according to the present invention preferably comprises at least three different electric field quenching devices, wherein one is able to emit green light, one is able to emit blue light and one is able to emit red light, as long as at least one of the electric field quenching devices is in accordance with the present invention. In a particularly preferred embodiment, the said display comprises at least three different electric field quenching devices all according to the present invention, wherein one of them emits green light, one of them emits blue light and one of them emits red light, characterized in that upon applying a suitable voltage on a desired field quenching device (FQD), the photoluminescence of the FQD is substantially quenched, preferably more than 50%, more preferably more than 60%, very preferably more than 70%, particularly more than 90%, and mostly preferably more than 95%

Either the electric field quenching device of the present invention or the display of the present invention is hermetically sealed in order to avoid that a lifetime of such a device or display is not shortened by the presence of water and/or air.

The display of the present invention typically comprises a backlight, a thin film transistor to driving the pixel, and the pixels comprising the field-quenching device according to the present invention. The display may be built up or contacted in a commonly known way, such as for example for LCD-displays.

An "alkyl" is preferably a linear, branched or cyclic alkyl-, alkenyl- or alkinylgroup having preferably 1 to 40 carbon atoms, more preferred 1 to 20 carbon atoms, and rather 3 to 40 carbon atoms, more preferred 3 to 20 carbon atoms. Cyclic alkylgroups may be mono-, bi- or polycyclic alkylgroups. One or more of the -CH- or -$CH_2$-groups may be substituted by N, NH, O or S. Examples are methyl, ethyl, n-propyl, i-propyl, n-butyl, i-butyl, s-butyl, t-butyl, 2-methylbutyl, n-pentyl, s-pentyl, t-pentyl, cyclopentyl, n-hexyl, cyclohexyl, n-heptyl, cycloheptyl, n-octyl, cyclooctyl, 2-ethylhexyl, trifluoromethyl, pentafluoroethyl, 2,2,2-trifluoroethyl, ethenyl, propenyl, butenyl, pentenyl, cyclopentenyl, hexenyl, cyclohexenyl, heptenyl, cycloheptenyl, octenyl, cyclooctenyl, ethinyl, propinyl, butinyl, pentinyl, hexinyl, heptinyl and octinyl.

The term "alkylsilyl" comprises mono-($C_{1-12}$-alkyl)-silylgroups, di-($C_{1-12}$-alkyl)-silylgroups und tri-($C_{1-12}$-alkyl)-silylgroups.

A "mono-($C_{1-12}$-alkyl)-silylgroup" of the present invention preferably means a ($SiH_2$)-unit, which is substituted with a linear or branched alkylgroup (as defined above) with 1 and rather 3 to 12 carbon atoms, more preferred 1 and rather 3 to 6 carbon atoms. A "di-($C_{1-12}$-alkyl)-silylgroup" of the present invention preferably means a (SiH)-unit, which is substituted with two linear or branched alkylgroups being the same or different and having 1 and rather 3 to 12 carbon atoms (as defined above), more preferred 1 and rather 3 to 6 carbon atoms. A "tri-($C_{1-12}$-alkyl)-silylgroup" preferably means a (Si)-unit, which is substituted with three linear or branched alkylgroups being same or different from each other and having 1 and rather 3 to 12 carbon atoms (as defined above), more preferred 1 and rather 3 to 6 carbon atoms.

The term "silyl" means a silylgroup having 1 and rather 3 to 5 silicon atoms which are linear or branched.

Examples are monosilyl, disilyl, trisilyl, tetrasilyl und pentasilyl.

An "arylsilyl" in the present invention is preferably a $Si_1$-silylgroup being substituted with one, two or three mono- or polycyclic aromatic or heteroaromatic ringsystems having 5 to 60 aromatic ringatoms.

An "alcoxyalkyl" in the present invention is a monovalent ether unit having two linear or branched alkylgroups (as defined above) having 1 and rather 3 to 12, more preferred 1 and rather 3 to 6 carbon atoms, which are bound via an oxygen atom.

An "arylalcoxyalkyl" in the present invention is a monovalent unit as defined below in connection with "alkoxyalkyl", wherein one alkylgroup is substituted with an aryl, which is a mono- or polycylic aromatic or heteroaromatic ringsystem having 5 to 60 aromatic ringatoms as defined below.

An "alkylthioalkyl" in the present invention is a monovalent thioether unit having two linear or branched alkylgroups (as defined above) with 1 and rather 3 to 12, more preferred 1 and rather 3 to 6 carbon atoms which are bound via a sulfur atom.

An "alkylsulfone" in the present invention is a $S(=O)_2$-unit which is substituted with an alkylgroup (as defined above) having 1 to 12 carbon atoms.

An "alkylsulfoxide" in the present invention is a -S(=O)-unit which is substituted with an alkylgroup (as defined above) having 1 to 12 carbon atoms.

A mono- or polycylic aromatic ringsystem is a ring system having 5 to 60 aromatic carbon atoms, more preferred 6 to 30, even more preferred 6 to 10 carbon atoms. A mono- or polycylic heteroaromatic ringsystem is a ring system having 5 to 60 aromatic ring atoms, more preferred 5 to 30 and even more preferred 5 to 14 ring atoms. The heteroaromatic ringsystem contains at least one heteroatom selected from N, O and S (the remaining atoms are carbon). Further the term mono- or polycylic aromatic or heteroaromatic ringsystem also means a system not necessarily having only aromatic or heteroaromatic groups, but wherein also one or more aromatic or heteroaromatic groups may be interrupted by a short non-aromatic unit (< 10 % of the atoms different from H, preferably < 5 %), such as $sp^3$-hybridised C, O, N, and so on.

Preferred aromatic ring system are for instance phenyl, biphenyl, triphenyl, naphthyl, anthracyl, binaphthyl, phenanthryl, dihydrophenanthryl, pyrene, dihydropyrene, chrysene, perylene, tetracene, pentacene, benzpyrene, fluorene und indene.

Preferred heteroaromatic ringsystems are for instance 5-membered rings, such as pyrrole, pyrazole, imidazole, 1,2,3-triazole, 1,2,4-triazole, tetrazole, furane, thiophene, selenophene, oxazole, isoxazole, 1,2-thiazole, 1,3-thiazole, 1,2,3-oxadiazole, 1,2,4-oxadiazole, 1,2,5-oxadiazole, 1,3,4-oxadiazole, 1,2,3-thiadiazole, 1,2,4-thiadiazole, 1,2,5-thiadiazole, 1,3,4-thiadiazole, 6-membered rings, such as pyridine, pyridazine, pyrimidine, pyrazine, 1,3,5-triazine, 1,2,4-triazine, 1,2,3-triazine, 1,2,4,5-tetrazine, 1,2,3,4-tetrazine, 1,2,3,5-tetrazine, or condensed groups, such as indole, isoindole, indolizine, indazole, benzimidazole, benzotriazole, purine, naphthimidazole, phenanthrimidazole, pyridimidazole, pyrazinimidazole, chinoxalinimidazole, benzoxazole, naphthoxazole, anthroxazole, phenanthroxazole, isoxazole, benzothiazole, benzofurane, isobenzofurane, dibenzofurane, chinoline, isochinoline, pteridine, benzo-5,6-chinoline, benzo-6,7-chinoline, benzo-7,8-chinoline, benzoisochinoline, acridine, phenothiazine, phenoxazine, benzopyridazine, benzopyrimidine, chinoxaline, phenazine, naphthyridine, azacarbazole, benzocarboline, phenanthridine, phenanthroline, thieno[2,3b]thiophene, thieno[3,2b]thiophene, dithienothiophene, isobenzothiophene, dibenzothiophene, benzothiadiazothiophene or combinations of these groups.

It will be appreciated that variations to the foregoing embodiments of the invention can be made while still falling within the scope of the invention. Each feature disclosed in this specification, unless stated otherwise, may be replaced by alternative features serving the same, equivalent or similar purpose. Thus, unless stated otherwise, each feature disclosed is one example only of a generic series of equivalent or similar features.

All of the features disclosed in this specification may be combined in any combination, except combinations where at least some of such features and/or steps are mutually exclusive. In particular, the preferred features of the invention are applicable to all aspects of the invention and may be used in any combination. Likewise, features described in non-essential combinations may be used separately (not in combination).

The teaching as disclosed here can be abstracted and combined with other examples disclosed.

Other features of the invention will become apparent in the course of the Figures and of the following description of exemplary embodiments, which are given for illustration of the invention and are not intended to be limiting thereof.

Description of the Figures 1 to 5:

Figure 1: Figure 1 shows an electric field quenching device in accordance with an example not forming part of the present invention. On a substrate (103) a first electrode layer (101) is arranged. On this first electrode an active layer (104) comprising the phosphorescent emitter compound and the charge transporting host compound is deposited. On the active layer (104) the second electrode (102) is arranged in the form of a layer.

Figure 2: Figure 1 shows an electric field quenching device according to the present invention. Between a first and a second electrode (210, 202) an active layer (204) comprising the phosphorescent emitter compound and the charge transporting host compound is located. The active layer (204) comprising the first and the second electrode at the two ends of the layer is arranged on an insulating layer (205). On the other side of the insulating layer (205) a third electrode (203) is located in the form of an layer.

Figure 3: Figure 3 shows the Braun model as explained above. By applying a bias to the electrodes the bound pair is split into free carriers. Then no relaxation into the ground stated is possible and phosphorescence may not occur.

Figure 4: Figure 4 shows a diagram of an electric field quenching device according to an example, not forming part of the present invention (in particular of a device as prepared in Example 4 below). On the abscissa the emitting wavelength of the phosphorescent emitter compound in the active layers is shown. On the ordinate the phosphorescence of the phosphorescent emitter compound is shown. Different curves are shown in the diagram in dependence of the voltage applied to the device.

Figure 5: Figure 5 shows a similar diagram as shown in Figure 4, with the sole difference that it shows the measurement results of the device as prepared in Example 5.

**Working Examples,** not according to the present invention, used to illustrate the principle of the present invention

**Example 1:**

**Matrix material I**

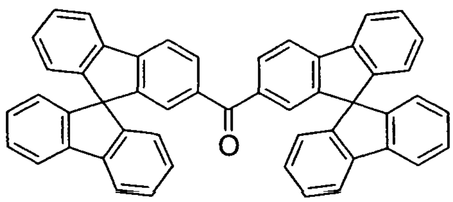

matrix **I**

Matrix I is an electron transport host compounds, and can be synthesized according to WO 2004/093207 A2.

**Example 2:**

**Complex** material I **and II**

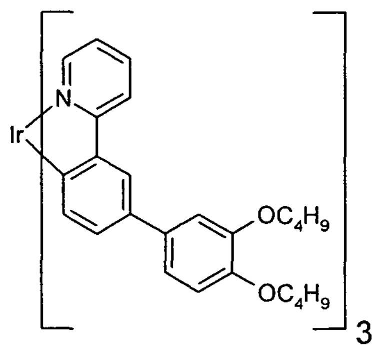

complex **I**

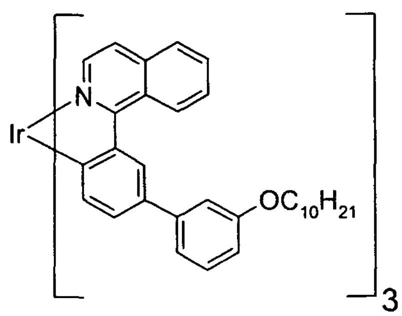

complex **II**

Complex I is a green emissive metal complex, and can be synthesized according to WO 2004/026886.

Complex **II** is a red emissive metal complex, and can be synthesized according to WO 2005/111172 A2.

**Example 3:**

**Energy levels by quantum chemistry simulation**

The quantum simulations on organic compouds are conducted employing Gaussian 03W (Gaussian Inc.). For organic compound comprising no metal, at first AM1 is used to optimize the molecular geometry, and TD-DFT (time-dependent density functional theory) with correction functional B3PW91 and basis set 6-31G(d) is used for energy calculations. For metal complexes comprising transition metals (incl. lanthanide and actinide), the geometry optimisation is conducted using Hartree-Fock method with Basis Set "LanL2MB"; and the energy calculation is then conducted by using TD-DFT with correction functional B3PW91 and basis set 6-31G(d) for non-metal elements and Lanz2DZ (Los Alamos National Laboratory 2-double-z) for transition metals. Results include HOMO/LUMO levels and energies for triplet and singlet excited states. The first triplet and first singlet excited states are most important, and will be called T1 and S1 levels thereafter.

From the energy calculation one gets HOMO HEh and LUMO HEh in Hartree units. And the HOMO and LUMO values in electron volts is determined with following equations, which are resulted from the calibration using cyclovoltametry measurements.

$$HOMO(eV) = ((HEh*27.212)-0.9899)/1.1206$$

$$LUMO(eV) = ((LEh*27.212)-2.0041)/1.385$$

These values will be used as HOMO-LUMO levels of the compounds in the present invention. As an example, for Matrix I (see also Table 1) a HOMO of -0.21249 Hartree and a LUMO of -0.06947 Hartree is obtained, which correspond a calibrated HOMO of -6.04 eV, and a calibrated LUMO of a calibrated -2.81 eV.

Table 1

| | HOMO [eV] | LUMO [eV] | T1 [eV] |
|---|---|---|---|
| Matrix **I** | -6.04 | -2.81 | 2.61 |
| Complex **I** | -5.23 | -2.43 | 2.58 |
| Complex **II** | -5.23 | -2.64 | 2.27 |

Wherein the $-OC_4H_9$ chain of complex **I** and $-OC_{10}H_{21}$ of complex **II** are reduced to $-OCH_3$ in the calculation.

As can be seen in Table 1, Matrix **I** has a lower LUMO than both Complex **I** and Complex **II**, and a T1 higher than both complexes.

**Example 4:**

**Preparation of electric field quenching device 1**

The electric field quenching device 1 is prepared by using matrix 1 as electron transporting host compound and complex 1 as phosphorescent emitter compound. The device is prepared in the following way:

(1) First electrode: aluminum is deposited on a glass substrate coated with indium-tin-oxide by thermal vacuum evaporation in order to obtain an aluminum layer on the substrate having a thickness of 25 nm;

(2) An active layer comprising 99 weight-% of matrix 1 and 1 weight-% complex 1 is deposited on the aluminum layer of the glass substrate by spin-coating a solution in chlorobenzene with a concentration of 1 weight-% based on the sum of complex material and matrix material yielding a layer having a thickness of 80 nm;

(3) Heating the device at 180°C for 10 minutes;

(4) Second electrode: aluminum is deposited by thermal vacuum evaporation onto the active layer in order to obtain an aluminum layer having a thickness of 150 nm;

**Example 5:**

**Preparation of electric field quenching device 2**

The electric field quenching device 2 is prepared as device 1 in Example 4 with the sole difference that not the complex **I,** but the complex **II** is used as phosphorescent emitter compound.

**Example 6:**

**Measurements and results**

The photoluminscence spectrums of the devices 1 and 2 as prepared in Examples 4 and 5 are recorded without and with different positive biases on the second electrode. The excitation wavelength for both phosphorescent materials are 350 nm.

Figure shows the field quenching photoluminescence of the device of Example 4. Surprisingly, the phosphorescence is almost completely (about 90%) suppressed at a voltage of 14 V. A similar result is obtained when using the device as prepared in Example 5, as shown in Figure 5, where the phosphorescence is not completely, but substantially (more than 55%) suppressed at a bias of 16 V.

## Claims

1. A photoluminescence quenching device induced by electric field comprising a first electrode negatively biased called cathode, a second electrode positively biased called anode and a third electrode (201, 202, and 203) and an active layer (204) in between the first and the second electrode, **characterized in that** the third electrode is isolated from the active layer by an insulating layer (205), and the active layer comprises at least one organic phosphorescent emitter compound and organic charge transporting host compound(s) being only hole transport host compound(s) wherein the cathode is selected from conducting materials, whose electron affinity is lower than the HOMO of the hole transport host compound(s) and wherein the HOMO of the hole transport host compound(s) is higher than that of the phosphorescent emitter compound.

2. The device according to claim 1, **characterized in that** the phosphorescent emitter compound is a photoluminescent organo-metal complex.

3. The device according to claim 2, **characterized in that** the organo-metal complex comprises a metal selected from transition metals, main group metals, lanthanides and actinides.

4. The device according to claim 2 or 3, **characterized in that** the metal complex comprises a metal selected from from Ir, Ru, Os, Eu, Au, Pt, Cu, Zn, Mo, W, Rh, Pd and Ag.

5. The device according to claim 1, **characterized in that** the said hole transporting host compound is selected from amines, triarylamines, thiophenes, carbazoles, phthalocyanines, porphyrines and derivatives thereof.

6. The device according to one or more of claims 1 to 5, **characterized in that** the active layer comprises at least one further emitter compounds, which is selected from an organic phosphorescent emitter, organic fluorescent emitter and colloidal quantum dots.

7. A display element comprising at least one device according to one or more claims of 1 to 6.

8. A process for controlling and/or regulating photoluminescence of the device according to one or more claims 1 to 6 which is able to quench the photoluminescence of an emitter compound when applying a respective voltage at the electrodes comprising the steps of

   (a) providing a device according to claims 1 to 6; and
   (b) providing an optical excitation by a light source to the device according to claims 1 to 6, wherein at least

partial light is absorbed by the active layer; and
(c) applying a voltage to the first and second electrodes of the device according to claims 1 to 6 and providing additional voltage on the third electrode so that at least 50 % of the photoluminescence of the phosphorescent emitter compound is quenched.

## Patentansprüche

1. Durch elektrisches Feld induzierte Photolumineszenz-Quenching-Vorrichtung, enthaltend eine erste, negativ vorgeladene Elektrode, die als Kathode bezeichnet wird, eine zweite, positiv vorgeladene Elektrode, die als Anode bezeichnet wird, und eine dritte Elektrode (201, 202 und 203) und eine Aktivschicht (204) zwischen der ersten und der zweiten Elektrode, **dadurch gekennzeichnet, dass** die dritte Elektrode von der Aktivschicht durch eine Isolierschicht (205) isoliert ist, und die Aktivschicht mindestens eine organische phosphoreszierende Emitterverbindung und organische ladungstransportierende Host-Verbindung(en), bei der/denen es sich nur um lochtransportierende Host-Verbindung(en) handelt, enthält, wobei die Kathode aus leitenden Materialien ausgewählt ist, deren Elektronenaffinität niedriger als das HOMO der lochtransportierenden Host-Verbindung(en) ist, und wobei das HOMO der lochtransportierenden Host-Verbindung(en) höher als das der phosphoreszierenden Emitterverbindung ist.

2. Vorrichtung nach Anspruch 1, **dadurch gekennzeichnet, dass** die phosphoreszierende Emitterverbindung ein photolumineszierender Organometallkomplex ist.

3. Vorrichtung nach Anspruch 2, **dadurch gekennzeichnet, dass** der Organometallkomplex ein aus Übergangsmetallen, Hauptgruppenmetallen, Lanthaniden und Aktiniden ausgewähltes Metall enthält.

4. Vorrichtung nach Anspruch 2 oder 3, **dadurch gekennzeichnet, dass** der Metallkomplex ein aus Ir, Ru, Os, Eu, Au, Pt, Cu, Zn, Mo, W, Rh, Pd und Ag ausgewähltes Metall enthält.

5. Vorrichtung nach Anspruch 1, **dadurch gekennzeichnet, dass** die lochtransportierende Host-Verbindung aus Aminen, Triarylaminen, Thiophenen, Carbazolen, Phthalocyaninen, Porphyrinen und Derivaten davon ausgewählt ist.

6. Vorrichtung nach einem oder mehreren der Ansprüche 1 bis 5, **dadurch gekennzeichnet, dass** die Aktivschicht mindestens eine weitere Emitterverbindung enthält, die aus einem organischen phosphoreszierenden Emitter, organischen fluoreszierenden Emitter und kolloidalen Quantenpunkten ausgewählt ist.

7. Anzeigeelement enthaltend mindestens eine Vorrichtung nach einem oder mehreren der Ansprüche 1 bis 6.

8. Verfahren zur Steuerung und/oder Regulierung der Photolumineszenz der Vorrichtung nach einem oder mehreren der Ansprüche 1 bis 6, das bei Anlegen einer entsprechenden Spannung an die Elektroden in der Lage ist, die Photolumineszenz einer Emitterverbindung zu löschen, umfassend die Schritte

   (a) Bereitstellen einer Vorrichtung nach den Ansprüchen 1 bis 6; und
   (b) Bereitstellen einer optischen Anregung durch eine Lichtquelle an die Vorrichtung nach den Ansprüchen 1 bis 6, wobei mindestens teilweises Licht durch die Aktivschicht absorbiert wird; und
   (c) Anlegen einer Spannung an die ersten und zweiten Elektroden der Vorrichtung nach den Ansprüchen 1 bis 6 und Bereitstellen zusätzlicher Spannung an der dritten Elektrode, so dass mindestens 50 % der Photolumineszenz der phosphoreszierenden Emitterverbindung gelöscht werden.

## Revendications

1. Dispositif d’extinction de la photoluminescence induite par un champ électrique, comprenant une première électrode polarisée négativement appelée cathode, une deuxième électrode polarisée positivement appelée anode et une troisième électrode (201, 202 et 203) et une couche active (204) entre les première et deuxième électrodes, **caractérisé en ce que** la troisième électrode est isolée de la couche active par une couche isolante (205), et la couche active comprend au moins un composé émetteur phosphorescent organique et un/des composé(s) hôte(s) de transport de charges organique(s) qui est/sont seulement un/des composé(s) hôte(s) de transport de trous, dans lequel la cathode est sélectionnée parmi les matériaux conducteurs dont l’affinité électronique est inférieure au niveau de HOMO du/des composé(s) hôte(s) de transport de trous et dans lequel le niveau de HOMO du/des

composé(s) hôte(s) de transport de trous est supérieur à celui du composé émetteur phosphorescent.

**2.** Dispositif selon la revendication 1, **caractérisé en ce que** le composé émetteur phosphorescent est un complexe organométallique photolu-minescent.

**3.** Dispositif selon la revendication 2, **caractérisé en ce que** le complexe organométallique comprend un métal qui est sélectionné parmi les métaux de transition, les métaux du groupe principal, les lanthanides et les actinides.

**4.** Dispositif selon la revendication 2 ou 3, **caractérisé en ce que** le complexe métallique comprend un métal qui est sélectionné parmi Ir, Ru, Os, Eu, Au, Pt, Cu, Zn, Mo, W, Rh, Pd et Ag.

**5.** Dispositif selon la revendication 1, **caractérisé en ce que** ledit composé hôte de transport de trous est sélectionné parmi les aminés, les triarylamines, les thiophènes, les carbazoles, les phtalocyanines, les porphyrines et leurs dérivés.

**6.** Dispositif selon une ou plusieurs des revendications 1 à 5, **caractérisé en ce que** la couche active comprend au moins un autre composé émetteur, lequel est sélectionné parmi un émetteur phosphorescent organique, un émetteur fluorescent organique et des points quantiques colloïdaux.

**7.** Élément d’affichage comprenant au moins un dispositif selon une ou plusieurs des revendications 1 à 6.

**8.** Procédé pour commander et/ou réguler la photoluminescence du dispositif selon une ou plusieurs des revendications 1 à 6, lequel dispose de la capacité de procéder à une extinction de la photoluminescence d’un composé émetteur lors de l’application d’une tension respective au niveau des électrodes, comprenant les étapes qui sont constituées par :

(a) la fourniture d’un dispositif selon les revendications 1 à 6 ; et
(b) l’application d’une excitation optique au moyen d’une source de lumière sur le dispositif selon les revendications 1 à 6, dans lequel au moins une lumière partielle est absorbée par la couche active ; et
(c) l’application d’une tension sur les première et deuxième électrodes du dispositif selon les revendications 1 à 6 et l’application d’une tension additionnelle sur la troisième électrode de telle sorte qu’au moins 50 % de la photoluminescence du composé émetteur phosphorescent subissent une extinction.

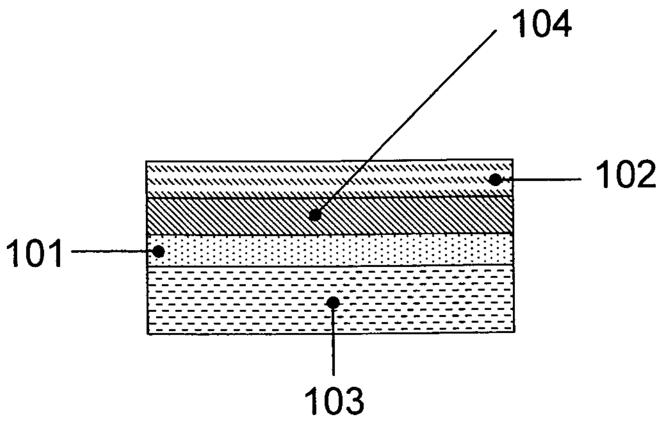


Figure 1

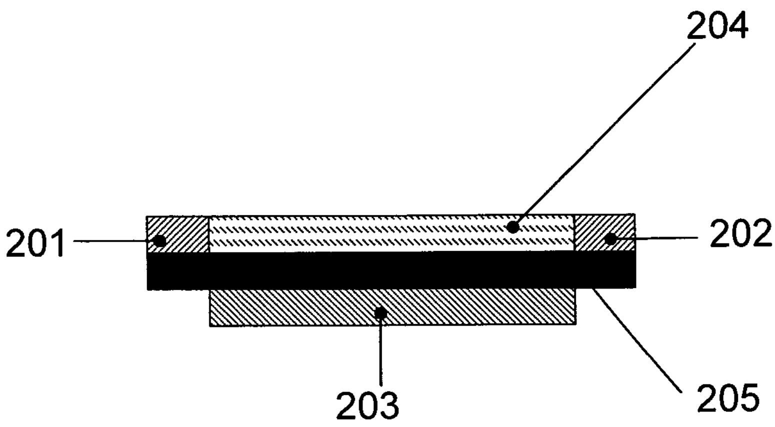


Figure 2

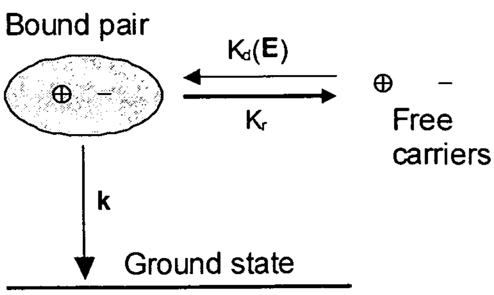


Figure 3

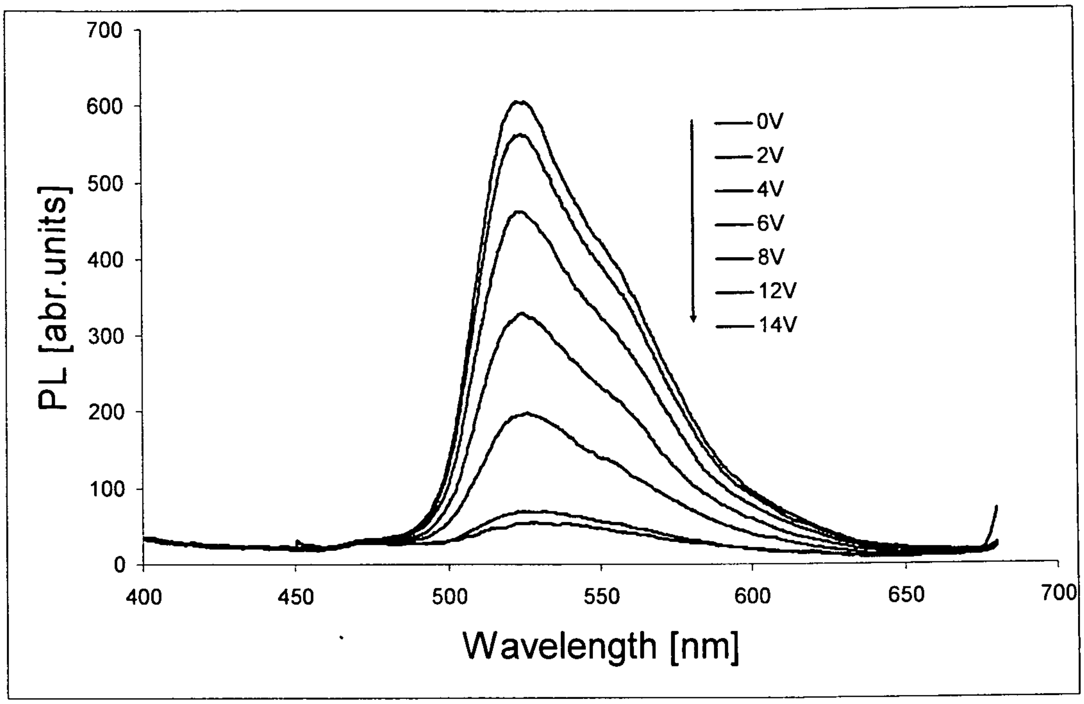


Figure 4

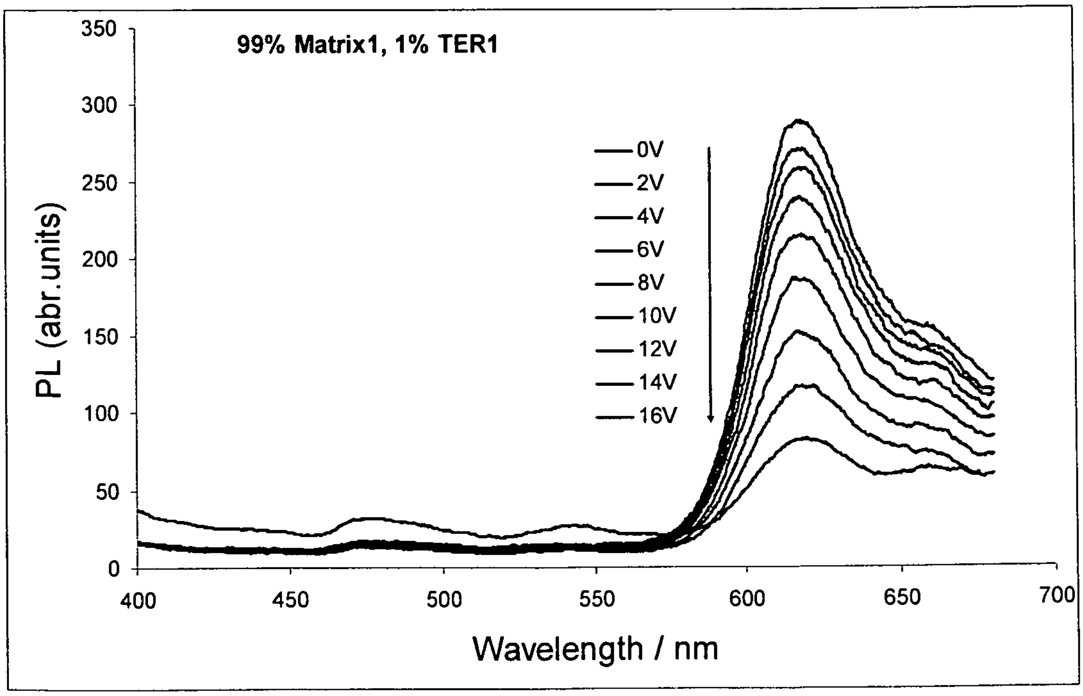


Figure 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- GB 2379317 A
- US 2004017148 A1
- DE 102005015359 A1
- US 20040227143 A1
- US 20040147701 A1
- US 20070176147 A
- US 20080142789 A
- JP 2007234989 B
- WO 007065 A
- WO 0141512 A
- WO 0202714 A
- WO 0215645 A
- EP 1191613 A
- EP 1191612 A
- EP 1191614 A
- WO 2005033244 A
- EP 278757 B1
- EP 0569827 A2
- US 200302309890 A
- US 5529853 A
- US 4356429 A
- US 4539507 A
- US 5766779 A
- JP 2003115387 A
- JP 2004311184 A
- JP 2001267080 A
- WO 2002043449 A
- EP 1480280 A
- EP 1478032 A
- EP 1469533 A
- JP 2004200162 A
- US 20070252517 A1
- US 20070122656 A1
- US 20070273272 A1
- US 20080193796 A1
- US 6878469 B2
- US 2006147747 A
- EP 1551206 A1
- US 3615404 A
- US 3567450 A
- US 3526501 A
- JP 56046234 A
- EP 1009041 A
- US 3615402 A
- JP 54110837 A
- US 3717462 A
- JP 61210363 A
- US 4950950 A
- JP 2204996 A
- JP 2282263 A
- JP 632956965 A
- US 4127412 A
- US 3180730 A
- US 4720432 A
- US 5061569 A
- JP 4308688 A
- US 20070092755 A1
- EP 1162193 A1
- EP 650955 A1
- DE 19646119 A1
- WO 2006122630 A1
- EP 1860097 A1
- EP 1834945 A1
- JP 08053397 A
- US 6251531 B1
- WO 2009041635 A
- WO 2005039246 A
- US 20050069729 A
- JP 2004288381 A
- EP 1205527 A
- DE 102007002714
- EP 1617710 A
- EP 1617711 A
- EP 1731584 A
- JP 2005347160 A
- WO 2004093207 A
- WO 2005003253 A
- WO 2007137725 A
- WO 2005111172 A
- DE 102008017591
- WO 2006117052 A
- US 20070134514 A1
- DE 102009023155
- EP 0906947 B1
- EP 0908787 B1
- EP 906948 B1
- WO 2008056746 A1
- WO 2007063754 A1
- WO 2008146839 A1
- WO 2008149691 A1
- EP 652273 B1
- EP 1923448 A1
- US 20060222886 A
- US 5121029 A
- US 5130603 A
- US 20070092753 A1
- WO 2006122630 A
- WO 2008006449 A

- WO 2007140847 A
- WO 2006000388 A
- WO 2006058737 A
- WO 2006000389 A
- WO 2007065549 A
- WO 2007115610 A
- US 7250532 B2
- DE 102005058557 A1
- CN 1583691 A
- US 2006210830 A
- EP 1957606 A1
- US 20080113101 A1
- US 4769292 A
- US 6020078 A
- US 796832 A
- US 20070102696 A1
- US 7095044 B
- WO 2004093207 A2
- WO 2004026886 A
- WO 2005111172 A2


**Non-patent literature cited in the description**


- **J. KALINOWSKI.** Electric-field-induced quenching of photoluminescence in photoconductive organic thin film structures based on Eu3+ complexes. *Journal of Applied Physics,* 2006, vol. 100, 034318
- **LI YUN-BAI.** Electric Field-Induced Quenching of photoluminescence from Ir(PPy)3 doped PVK. *Chin.Phys.Lett,* 2004, vol. 21 (7), 1362
- **L. ONSAGER.** *J. Chem, Phys.,* 1934, vol. 2, 599
- *Phys. Rev.,* 1938, vol. 54, 554
- **C. L. BRAUN.** *J. Chem. Phys.,* 1984, vol. 80, 4157
- **PAN, J. et al.** *J. Chem. Phys.,* 2000, vol. 112 (9), 4305-4309
- *Synth. Metals,* 1997, vol. 91 (1-3), 209
- **M. FISCHER et al.** Int. Ed. *Angew. Chem.,* 1999, vol. 38, 885
- **C.H. CHEN et al.** Recent developments in organic electroluminescent materials. *Macromol. Symp.,* 1997, vol. 125, 1-48
- Recent progress of molecular organic electroluminescent materials and devices. *Mat. Sci. and Eng. R,* 2002, vol. 39, 143-222
- **ALIVISATOS, A. P.** Semiconductor clusters, nanocrystals, and quantum dots. *Science,* 1996, vol. 271, 933
- **X. PENG ; M. SCHLAMP ; A. KADAVANICH ; A. P. ALIVISATOS.** Epitaxial growth of highly luminescent CdSe/CdS Core/Shell nanocrystals with photostability and electronic accessibility. *J. Am. Chem. Soc.,* 1997, vol. 30, 7019-7029
- **C. B. MURRAY ; D. J. NORRIS ; M. G. BAWENDI.** Synthesis and characterization of nearly monodisperse CdE (E=sulfur, selenium, tellurium) semiconductor nanocrystallites. *J. Am. Chem. Soc.,* 1993, vol. 115, 8706
- **MOONSUB SHIM ; PHILIPPE GUYOT-SIONNEST.** n-type colloidal semiconductor nanocrystals. *Nature,* 2000, vol. 407, 981
- **NORRIS et al.** Doped Nanocrystals. *Science,* 2008, vol. 319, 1776
- **X. PENG et al.** *J. Am. Chem. Soc.,* 1997, vol. 30, 7019-7029
- Polymer Handbook. John Willey & Sons, Inc, 1999, VI/193-VI/276
- **M. S. ARNOLD et al.** *Appl. Phys. Lett.,* 2008, vol. 92, 053301